(19) Europäisches Patentamt
European Patent Office
Office européen des brevets

(11) **EP 3 701 274 B1**

(12) **EUROPÄISCHE PATENTSCHRIFT**

(45) Veröffentlichungstag und Bekanntmachung des Hinweises auf die Patenterteilung:
**11.12.2024 Patentblatt 2024/50**

(21) Anmeldenummer: **18795342.7**

(22) Anmeldetag: **19.10.2018**

(51) Internationale Patentklassifikation (IPC):
**G01R 1/20** (2006.01)    **G01R 35/00** (2006.01)
**G01R 31/3842** (2019.01)

(52) Gemeinsame Patentklassifikation (CPC):
**G01R 1/203; G01R 31/3842; G01R 35/005**

(86) Internationale Anmeldenummer:
**PCT/EP2018/078690**

(87) Internationale Veröffentlichungsnummer:
**WO 2019/081365 (02.05.2019 Gazette 2019/18)**

(54) **VERFAHREN ZUM BETRIEB EINES BATTERIESENSORS UND BATTERIESENSOR**

METHOD FOR OPERATING A BATTERY SENSOR, AND BATTERY SENSOR

PROCÉDÉ POUR FAIRE FONCTIONNER UN CAPTEUR DE BATTERIE ET CAPTEUR DE BATTERIE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **24.10.2017 DE 102017219016**

(43) Veröffentlichungstag der Anmeldung:
**02.09.2020 Patentblatt 2020/36**

(73) Patentinhaber: **Continental Automotive Technologies GmbH**
**30175 Hannover (DE)**

(72) Erfinder:
• **GRAF, Hans-Michael**
**93049 Regensburg (DE)**
• **SCHRAMME, Martin**
**86343 Königsbrunn (DE)**
• **AUMER, Andreas**
**93133 Burglengenfeld (DE)**
• **FRIMBERGER, Manfred**
**84061 Ergoldsbach (DE)**

(74) Vertreter: **Continental Corporation**
**c/o Continental Automotive Technologies GmbH**
**Intellectual Property**
**Guerickestraße 7**
**60488 Frankfurt a. Main (DE)**

(56) Entgegenhaltungen:
**DE-A1- 102016 202 501    DE-A1- 102016 204 941**

**Beschreibung**

Die Erfindung betrifft ein Verfahren zum Betrieb eines Batteriesensors nach dem Oberbegriff des Anspruchs 1 sowie einen Batteriesensor nach dem Oberbegriff des Anspruchs 11.

Solche Batteriesensoren enthalten insbesondere Vorrichtungen zur Messung der Batteriespannung, des von der Batterie aufgenommenen oder abgegebenen Batteriestroms und der Umgebungstemperatur der Batterie. Üblicherweise beinhaltet der Batteriesensor auch einen Mikrocontroller, der diese Messdaten zwischenspeichert, filtert und daraus weitere Batteriegrößen, beispielsweise den Ladezustand oder den Innenwiderstand der Batterie berechnet.

Zur Messung des Laststroms kommen bei Ausführungen gemäß dem Stand der Technik hochgenaue Widerstände oder Sensoren zur Messung der magnetischen Feldstärke zum Einsatz. Nachteilig an den bisherigen Ausführungen sind insbesondere die hohen Kosten, insbesondere zur Herstellung von Widerstandsmaterialien, welche in einem üblichen Temperaturbereich von -40°C bis 105°C mehr oder weniger konstante Widerstandswerte aufweisen. Ein Beispiel eines solchen Materials ist eine Kupfer-Nickel-Mangan-Legierung.

Seit einiger Zeit gibt es Ansätze, einen hochpräzisen Widerstand als Messwiderstand, auch als Shunt-Widerstand bezeichnet, durch kostengünstigere Bauteile zu ersetzen. Eine Möglichkeit ist es, einen Shunt-Widerstand über die Lebensdauer des Batteriesensors immer wieder nachzukalibrieren.

Die Druckschrift EP 1378757 A2 schlägt vor einen Referenzwiderstand parallel zum Messwiderstand zu schalten und die am Messwiderstand und am Referenzwiderstand jeweils auftretende elektrische Größe auszuwerten.

Die Druckschrift WO 2016/041658 A1 offenbart ein Kalibrierungsverfahren eines Batteriesensors durch Einprägen eines bekannten Referenzstroms in einen Messwiderstand und Erfassen eines Kalibrierungsspannungsabfalls.

Die DE 10 2016 202 501 A1 offenbart einen Batteriesensor mit zwei in Reihe geschalteten Messwiderständen, wobei zusätzlich zum Laststrom ein Kalibrierstrom durch zumindest einen Messwiderstandgeleitet wird und basierend auf den gemessenen Spannungspulsen ein Kalibrierstrompuls berechnet wird.

Es hat sich jedoch herausgestellt, dass eine ständige Nachkalibrierung auch während der gleichzeitigen Messung der im Kraftfahrzeug auftretenden hohen und zeitlich stark veränderlichen Ströme unter den herrschenden Randbedingungen, insbesondere eines erwünschten niedrigen Stromverbrauchs des Sensors, schwierig ist, da der zum Kalibrieren anzulegende Referenzstrom klein gewählt werden soll und nur kurzzeitig anliegen soll.

Aufgabe der Erfindung ist es, ein Verfahren zum Betrieb eines Batteriesensors, welches im Vergleich zu bekannten Ausführungen, mit einem geringen Aufwand bzw. mit einem einfacheren Aufbau des Batteriesensors auszuführen ist, sowie einen Batteriesensor zur Durchführung dieses Verfahrens bereitzustellen, wobei der Batteriesensor einen einfacheren und kostengünstigeren Aufbau aufweist.

Die Aufgabe wird erfindungsgemäß durch ein Verfahren nach Anspruch 1 und einen Batteriesensor nach Anspruch 11 erreicht. Vorteilhafte Ausführungen können beispielsweise den jeweiligen Unteransprüchen entnommen werden. Der Inhalt der Ansprüche wird durch ausdrückliche Inbezugnahme zum Inhalt der Beschreibung gemacht.

Zur Lösung der Aufgabe ist ein Verfahren zum Betrieb eines Batteriesensors vorgesehen, wobei der Batteriesensor zumindest einen ersten Batteriesensoranschluss und einen zweiten Batteriesensoranschluss, sowie einen Laststromanschluss, eine Strommessvorrichtung zur Erfassung eines Laststroms, mit einem ersten Messwiderstandselement und einem zweiten Messwiderstandselement, wobei das erste und das zweite Messwiderstandselement zwischen dem Laststromanschluss und dem zweiten Batteriesensoranschluss in Reihe geschaltet sind, und eine Referenzstromschaltung mit zumindest einem Referenzwiderstand, wobei der Referenzwiderstand mit dem ersten Batteriesensoranschluss und einem zwischen den Messwiderstandselementen vorgesehenen Kontaktpunkt kontaktiert ist, umfasst.

Der elektrische Widerstand des ersten Messwiderstandselements wird ermittelt durch

- Zuschalten eines Referenzstroms und Erfassen der jeweiligen resultierenden Spannungsabfälle über das erste und das zweite Messwiderstandselement sowie der Batteriespannung,
- Bestimmen des Referenzstroms aus dem Quotienten der Batteriespannung und dem elektrischen Widerstand des Referenzwiderstandes, und
- Bestimmen des elektrischen Widerstands des ersten Messwiderstandselements aus den erfassten Spannungsabfällen, dem Referenzstrom und zumindest einem Korrekturfaktor, der das Verhältnis zwischen dem elektrischen Widerstand des ersten Messwiderstandselements und dem elektrischen Widerstand des zweiten Messwiderstandselements charakterisiert.

Zur Lösung der Aufgabe ist des Weiteren ein Batteriesensor zur Bestimmung eines Batteriezustandes einer Batterie, insbesondere einer Fahrzeugbatterie, vorgesehen, umfassend zumindest einen ersten Batteriesensoranschluss und einen zweiten Batteriesensoranschluss, sowie einen Laststromanschluss, eine Spannungsmessvorrichtung zur Erfassung der elektrischen Spannung am ersten Batteriesensoranschluss, eine Strommessvorrichtung zur Erfassung des Laststroms, mit einem ersten Messwiderstandselement und einem zweiten Messwiderstandselement, wobei das erste und das zweite Messwiderstandselement zwischen dem Laststromanschluss und dem zweiten Batteriesensoranschluss in Reihe geschaltet sind, und wobei eine erste und eine zweite Spannungsmesseinrichtung zur Erfassung jeweils des Spannungsabfalls über das erste und das zweite Messwiderstandelement vorgesehen sind, eine Referenzstromschaltung mit zumindest einem Referenzwiderstand, wobei der Referenzwiderstand mit dem ersten Batteriesensoranschluss und einem zwischen den Messwiderstandelementen vorgesehenen Kontaktpunkt kontaktiert ist, und eine Steuerung zur Ermittlung des Laststroms und des Batteriezustandes, mit dem erfindungsgemäßen Verfahren.

Der Laststrom und/oder der Batteriezustand werden mit dem vorstehend beschriebenen und nachfolgend im Detail erläuterten Verfahren bestimmt.

Üblicherweise ist an einer Steuerung oder Auswerteeinheit jeweils ein Eingang für die Batteriespannung, die zwei Spannungsabfälle über den Messwiderstandelementen, für einen Temperatursensor sowie zur Bestimmung der Größe des Referenzstroms erforderlich. Es sind also bevorzugt mindestens fünf Eingänge erforderlich, um alle Batterieparameter, die zur Bestimmung des Batteriezustandes erforderlich sind, zu erfassen.

Zweckmäßigerweise werden nur jeweils drei Signale gleichzeitig benötigt, wobei die Signale für definierte Zeiträume bzw. Messintervalle gewechselt werden. Die Steuerung benötigt somit nur drei Eingänge. Dies ist insbesondere von Vorteil, wenn die Signale für die Weiterverarbeitung oder für die Bestimmung der Batterieparameter digitalisiert werden sollen, da dadurch die Anzahl der benötigten Analog/Digital-Wandler ebenfalls auf drei reduziert werden kann.

Im regulären Betrieb erfolgt die Bestimmung des Laststroms vorzugsweise über die Erfassung der Spannungsabfälle über die Messwiderstandelemente. Über das ohmsche Prinzip kann mit den bekannten elektrischen Widerständen der Messwiderstandelemente der Laststrom bestimmt werden. Hierzu werden die Signale der ersten und optional die Signale der zweiten Spannungsmesseinrichtung an die Steuerung ausgegeben.

Um die Messwiderstandelemente zweckmäßigerweise zu kalibrieren, wird der Referenzstrom an den Kontaktpunkt zwischen dem ersten und dem zweiten Messwiderstandelement angelegt, wobei der Referenzstrom im Wesentlichen durch das erste Messwiderstandelement getrieben wird. Über die Änderung der gemessenen Spannungsabfälle über die Messwiderstandelemente bzw. durch die Messung des Spannungsabfalls über das erste Messwiderstandelement und einer bekannten oder vorab ermittelten Verhältnismäßigkeit zwischen den elektrischen Widerstände der Messwiderstandelemente kann der genaue elektrische Widerstand des ersten Messwiderstandelement, und über die bekannte Verhältnismäßigkeit auch der elektrische Widerstand des zweiten Messwiderstandelements ermittelt werden. Die Verhältnismäßigkeit zwischen den Messwiderstandelementen ist beispielsweise durch Korrekturfaktoren dargestellt, wobei gilt: $U1 = U2 \cdot \alpha + \beta$.

Üblicherweise bzw. beispielhafterweise wird der Referenzstrom hochgenau bereitgestellt oder es erfolgt eine Erfassung der Größe des Messstroms, wobei eine zusätzliche Messeinrichtung sowie ein zusätzlicher Analog/Digital-Wandler erforderlich sind. Gemäß dem vorstehend beschriebenen Verfahren wird der Messstrom bevorzugt aus dem Quotienten des zeitgleich erfassten Batteriestroms und dem bekannten elektrischen Widerstand des Referenzwiderstandes bestimmt.

Zeitgleich erfolgt über die Spannungsmessvorrichtung bevorzugt eine permanente Erfassung der Batteriespannung. Die Referenzstromschaltung ist direkt mit dem Batteriesensoranschluss, an dem auch die Batteriespannung erfasst wird, kontaktiert. Das heißt, der Referenzstrom bzw. der Spannungsabfall am Referenzwiderstand ist direkt abhängig von der Batteriespannung, insbesondere proportional zu dieser. Da die Batteriespannung permanent erfasst wird, ist also keine separate Spannungsmessung am Referenzwiderstand erforderlich. Der Referenzstrom entspricht dem Quotienten aus der Batteriespannung und dem elektrischen Widerstand des Referenzwiderstandes.

Zur Ermittlung des Referenzstromes und somit zur Ermittlung des genauen elektrischen Widerstandes des ersten Widerstandelements sind somit zweckmäßigerweise keine separate Erfassungseinrichtung und kein separater Eingang für die Steuerung erforderlich. Der Referenzstromes und der genaue elektrische Widerstand des ersten Widerstandelements werden aus den an der Steuerung anliegenden drei Signalen ermittelt.

Es sind zweckmäßigerweise keine zusätzlichen Schaltelemente, insbesondere keine weiteren Analog/Digital-Wandler, erforderlich.

Des Weiteren sind vorzugsweise keine Schaltelemente zur Regulierung des Referenzstroms erforderlich, da dieser mit dem vorstehend beschriebenen Verfahren bestimmt wird. Zwischen dem Batteriesensoranschluss und der Referenzstromschaltung sind also keine Schaltelemente, insbesondere zur Regulierung des Referenzstroms, vorgesehen. Es ist nur ein Schalter zum Ein- und Ausschalten des Referenzstroms erforderlich.

Die Referenzstromschaltung ist vorzugsweise so ausgebildet, dass diese keinen Stromregler umfasst, bzw. kein zusätzliches elektrisches Bauteil zwischen dem Batteriesensoranschluss und der Referenzstromschaltung vorgesehen ist.

Es sei erwähnt, dass der elektrische Widerstand des Referenzwiderstandes bevorzugt um ein Vielfaches größer ist als die elektrischen Widerstände der Messwiderstandelemente, vorzugsweise mindestens um den Faktor 1000. Der Spannungsabfall des Referenzstroms an den Messwiderstandelementen ist daher deutlich geringer als der Spannungsabfall des Referenzstroms am Referenzwiderstand, so dass dieser für die Berechnung des Referenzstroms vernachlässigt werden kann.

Grundsätzlich können auch mehrere erste und mehrere zweite Messwiderstandelemente vorgesehen sein,

wobei die erste und die zweite Spannungsmesseinrichtungen entweder jeweils die Spannungsabfälle über alle erste und alle zweite Messwiderstandelemente erfassen können und/oder für jedes Messwiderstandelement eine separate Spannungsmesseinrichtung vorgesehen sein kann.

Mit dem vorstehend beschriebenen Verfahren kann der Laststrom und die Batteriespannung mit zweckmäßigerweise lediglich drei Analog-Digital-Wandlern ermittelt werden, wobei die Laststrommessung aufgrund der permanenten Nachkalibrierung des Messwiderstands hochpräzise ist. Dies ist besonders vorteilhaft, da erhältliche integrierte Schaltkreise zum Einsatz in Batteriesensoren üblicherweise maximal drei Analog-Digital-Wandler enthalten.

Der Laststrom wird vorzugsweise bestimmt durch Abschalten des Referenzstroms und Erfassen des Spannungsabfalls über das erste Messwiderstandelement. Grundsätzlich können für die Laststrommessung die Spannungsabfälle an beiden Messwiderstandelementen genutzt werden. Durch das vorstehend beschriebene Verfahren sind die elektrischen Widerstände beider Messwiderstandelemente genau bestimmt, so dass eine sehr genaue Strommessung erfolgen kann. Eine zuverlässige und genaue Strommessung ist aber auch möglich, wenn nur ein Spannungsabfall und der genau bestimmte elektrische Widerstand des entsprechenden Messwiderstandelements bekannt sind. Der Eingang der Steuerung, mit dem der jeweils andere Spannungsabfall erfasst wird, kann stattdessen zur Erfassung eines anderen Batterieparameters verwendet werden. Es ist also eine permanente Strommessung, eine permanente Batteriespannungserfassung und die Erfassung zusätzlicher Batterieparameter möglich, wobei nur drei Eingänge an der Steuerung erforderlich sind. Insbesondere, wenn die Signale vor der Erfassung durch die Steuerung digitalisiert werden sollen, kann dadurch die Anzahl der Analog/Digital-Wandler reduziert werden. Es sind nur drei Analog/Digital-Wandler an oder vor den drei Eingängen der Steuerung erforderlich. Vorzugsweise erfolgt die Ermittlung des Laststroms über den Spannungsabfall am ersten Messwiderstandelement permanent, das heißt, unterbrechungsfrei.

Vorzugsweise erfolgt gleichzeitig mit der Bestimmung des Laststroms über den Spannungsabfall am ersten Widerstandelement eine Ermittlung eines Batteriezustandes durch ein Erfassen der Batteriespannung, ein Bestimmen des Laststroms aus dem Spannungsabfall über das erste Messwiderstandelement, und ein Erfassen eines Batterieparameters mit einem Sensor, insbesondere Erfassen einer Temperatur mit einem Temperatursensor.

Wie vorstehend erläutert wird, sind zur Bestimmung des Batteriezustandes und zur genauen Bestimmung der elektrischen Widerstände der Messwiderstandelemente nur drei Eingänge an der Steuerung bevorzugt erforderlich, d.h. es müssen unabhängig davon, welche Funktion aktuell durchgeführt wird, nur drei Signale von der Steuerung erfasst und verarbeitet werden.

Der zumindest eine Korrekturfaktor wird beispielsweise aus den jeweiligen Spannungsabfällen und/oder den Verläufen der Spannungsabfälle des Laststroms über das erste und das zweite Messwiderstandelement bei abgeschaltetem Referenzstrom bestimmt. Das heißt, an die Messwiderstandelemente wird lediglich der Laststrom angelegt und es werden durch die erste und die zweite Spannungsmesseinrichtung jeweils die Spannungsabfälle über das erste und das zweite Messwiderstandelement erfasst. Aus den erfassten Spannungsabfällen kann der zumindest eine Korrekturfaktor bestimmt werden. Der Korrekturfaktor kann beispielsweise ein lineares Verhältnis zwischen gemessenen Spannungsabfallen oder Offset darstellen. Mit dem zumindest einen Korrekturfaktor kann aus einem erfassten Spannungsabfall bzw. dem bestimmten elektrischen Widerstand eines Messwiderstandelements die am anderen Messwiderstandelement abfallende Spannung bzw. der elektrische Widerstand des anderen Messwiderstandes berechnet werden.

Um den Batteriezustand vollständig zu erfassen sind also drei Schritte bzw. drei Messintervalle vorzugsweise erforderlich. Zunächst werden in einem ersten Zeitintervall die Korrekturfaktoren bestimmt, wobei aus den gemessenen Spannungsabfällen auch ein Laststrom bestimmt werden kann. In einem zweiten Zeitintervall erfolgt die Bestimmung der genauen elektrischen Widerstände der Messwiderstandelemente oder zumindest des genauen elektrischen Widerstandes des ersten Messwiderstandelements. Nachfolgend wird in einem dritten Zeitintervall der genaue Laststrom bestimmt und/oder der Batteriezustand ermittelt. Die drei Schritte des Bestimmens des elektrischen Widerstandes des ersten Messwiderstandelements, des Bestimmens des Laststroms, der Ermittlung des Batteriezustandes und/oder der Erfassung des Batterieparameters mit dem Sensor werden vorzugsweise wechselweise, insbesondere periodisch, wiederholt.

Die Wiederholfrequenz der einzelnen Zeitintervalle kann dabei bevorzugt variieren. Beispielsweise muss die Bestimmung einer Temperatur, also eine Batterieparameter oder die Bestimmung der Korrekturfaktoren weniger häufig erfolgen, da sich diese nur langsam ändern.

Die zeitliche Länge der einzelnen Zeitintervalle kann ebenso variieren, in Abhängigkeit davon, wie schnell und/oder genau die einzelnen Parameter bestimmt werden können oder sollen.

Vorzugsweise ist der Referenzwiderstand sehr genau bzw. weist nur eine sehr geringe temperaturbedingte oder alterungsbedingte Änderung des elektrischen Widerstandes auf. Mit der Batteriespannung und dem sehr genauen elektrischen Widerstand ist eine sehr genaue Bestimmung des Referenzstroms und somit des elektrischen Widerstandes des ersten und des zweiten Messwiderstandelements möglich.

Der Referenzwiderstand kann aber auch aus mehreren Referenzteilwiderständen bestehen, wobei nur ein Referenzteilwiderstand hochgenau sein muss. Beispielsweise wird ein hochgenauer Referenzteilwiderstand mit einem geringen elektrischen Widerstand mit einem weiteren Referenzteilwiderstand mit geringerer Genauigkeit und höherem Widerstand in Reihe geschaltet. Die Kosten für den hochgenauen Referenzteilwiderstand können so reduziert werden, da der hochgenau Referenzteilwiderstand nicht auf die gesamte am Referenzwiderstand abfallende Spannung ausgelegt sein muss. In einem vorstehend beschriebenen Verfahren weist der Referenzwiderstand daher wenigstens einen ersten Referenzteilwiderstand und einen zweiten Referenzteilwiderstand aufweist, und eine Bestimmung des Referenzwiderstandes erfolgt durch Zuschalten des Referenzstroms in die Messwiderstandsgruppe aus wenigstens einem ersten Referenzteilwiderstand und einem zweiten Referenzteilwiderstand, Erfassen einer Spannung an einem Spannungsabgriffspunkt zwischen den Referenzteilwiderständen, Erfassen der Batteriespannung ,Bestimmen des Teilerverhältnisses aus der erfassten Spannung und der erfassten Batteriespannung und Bestimmen des elektrischen Widerstandes des zweiten Referenzteilwiderstandes aus dem Teilerverhältnis und dem bekannten elektrischen Widerstand des ersten Referenzteilwiderstandes.

Das heißt bevorzugt, aus dem bekannten - relativ kleinen - elektrischen Widerstand des hochgenauen Referenzteilwiderstand wird der - größere - elektrische Widerstand des zweiten Referenzteilwiderstandes und somit der elektrische Widerstand des Referenzwiderstandes bestimmt. Es ist nicht erforderlich, dass der gesamte Spannungsabfall am Referenzwiderstand über einen hochgenauen Widerstand erfolgt.

Dieser Schritt kann ebenfalls periodisch in einem weiteren Messintervall wiederholt werden. Es sei nochmals darauf hingewiesen, dass auch für die Kalibrierung des Referenzwiderstades nur drei Signale erforderlich sind.

Die Erfassung der Spannungen, der Spannungsabfälle und die Erfassung der Batterieparameters erfolgt vorzugsweise mit drei Analog/Digital-Wandler, wobei ein erster Analog/Digital-Wandler zur Erfassung des Spannungsabfalls über das erste Messwiderstandselement, ein zweiter Analog/Digital-Wandler zur wahlweisen Erfassung des Spannungsabfalls über das zweite Messwiderstandselement oder des Batterieparameters des einen Sensors und ein dritter Analog/Digital-Wandler zur Erfassung der Batteriespannung vorgesehen ist.

Üblicherweise bzw. beispielhafterweise wird für die Erfassung jedes Spannungsabfalls, für die Spannungsabfälle an den Messwiderstandselementen sowie am Referenzwiderstand jeweils ein separater Analog/Digital-Wandler benötigt. Zusätzlich wird jeweils ein Analog/Digital-Wandler für die Erfassung der Batteriespannung sowie von weiteren Sensordaten, beispielsweise eines Temperatursensors, benötigt. Dies ist insbesondere erforderlich, um eine unterbrechungsfreie Strommessung des Laststroms sowie eine unterbrechungsfreie Erfassung der Batteriespannung zu gewährleisten. Dies ist erforderlich, um eine konstante und somit zuverlässige Bestimmung des Batteriezustandes zu gewährleisten. Mit dem vorstehend beschriebenen Verfahren können mit lediglich drei Analog/Digital-Wandler alle Daten erfasst und der Batteriezustand ermittelt werden. Hierbei werden ein Analog/Digital-Wandler zur Erfassung der Batteriespannung und mindestens ein Digital-Wandler für die Erfassung des Laststroms verwendet. Der zweite Analog/Digital-Wandler wird wechselweise zur Bestimmung der Korrekturfaktoren, zur Erfassung des Laststroms oder zur Erfassung eines anderen Signals, beispielsweise eines Temperatursignals, verwendet. Zudem werden die Signale mehrfach verwendet. So wird beispielsweise der erfasste Batteriestrom auch zur Ermittlung des Referenzstroms bzw. zur Kalibrierung des Referenzwiderstandes verwendet.

Optional können vorzugsweise an zwei Analog/Digital-Wandler dieselben Eingangssignale angelegt werden, um diese kalibrieren bzw. abzugleichen. Beispielsweise erfolgt eine Bestimmung eines Kalibrierfaktors des zweiten oder des dritten Analog/Digital-Wandler, durch Anlegen der gleichen Batteriespannung, des gleichen Spannungsabfalls und/oder des gleichen Parameters eines Sensors an den zweiten und den dritten Analog/Digital-Wandler.

Beispielsweise wird mit dem zweiten und dem dritten Analog/Digital-Wandler gleichzeitig die Batteriespannung erfasst. Die Werte können miteinander verglichen und ein Kalibrierfaktor für den zweiten oder den dritten Analog/Digital-Wandler bestimmt werden. Hierzu kann gegebenenfalls ein Spannungsteiler vorgesehen werden, um die Batteriespannung zu teilen. Der Vorteil dieses Kalibrierverfahrens liegt darin, dass die Batteriespannungsmessung unterbrechungsfrei fortgesetzt werden kann und das Verfahren ebenfalls mit den vorhandenen drei Signaleingängen ausführbar ist.

Alternativ oder bevorzugt ergänzend kann mit den zweiten und den dritten Analog/Digital-Wandler jeweils eine an einem Spannungsabgriffspunkt zwischen dem ersten Referenzteilwiderstand und dem zweiten Referenzteilwiderstand des Referenzwiderstandes anliegende Spannung erfasst werden, um zumindest einen Kalibrierfaktor zu bestimmen. Hierzu ist beispielsweise kein Spannungsteiler erforderlich, so dass eine Kalibrierung mit einfachen Mitteln ohne zusätzliche elektronische Bauteile möglich ist.

Die Spannungsmessvorrichtung und/oder die erste und die zweite Spannungsmesseinrichtungen weisen vorzugsweise einen Analog-Digital-Wandler auf.

Es kann zumindest ein Sensor zur Erfassung eines Batterieparameters vorgesehen sein und der zweiten Spannungsmesseinrichtung kann ein Umschalter, insbesondere ein Multiplexer, zum Umschalten zwischen einem Signal der zweiten Spannungsmesseinrichtung und einem Signal des Sensors zugeordnet sein, wobei der Umschalter insbesondere vor einem Analog-Digital-Wandler der zweiten Spannungsmesseinrichtung vorgesehen ist. Durch den Umschalter kann der Analog/Digital-Wandler mehrere verschiedene Signale Erfassung, so dass eine Mehrfachnutzung des Analog/Digital-Wandler möglich ist. Somit kann, insbesondere bei Durchführung des vorstehend beschriebenen Verfahrens, die Anzahl der Analog/Digital-Wandler auf drei reduziert werden. Vorzugsweise weist der Batteriesensor insgesamt nur drei Analog/Digital-Wandler auf.

Unter einem Umschalter, insbesondere einem Multiplexer, sei insbesondere eine Selektionsschaltung verstanden, mit der aus einer Anzahl von Eingangssignalen eines ausgewählt und an den Ausgang durchgeschaltet werden kann.

Die Referenzstromschaltung weist beispielsweise ein in Reihe mit dem Referenzwiderstand angeordnetes Schalterelement auf, um den Referenzstrom zu- oder abschalten zu können.

Der Referenzwiderstand kann vorzugsweise zumindest zwei in Reihe angeordnete Referenzteilwiderstände aufweisen, wobei zwischen den Referenzteilwiderstände ein Spannungsabgriffspunkt vorgesehen ist. Der Spannungsmessvorrichtung kann ein Umschalter zum wahlweisen Erfassen der Batteriespannung oder der am Spannungsabgriffspunkt anliegenden Spannung zugeordnet sein, wobei der Umschalter insbesondere vor einem Analog-Digital-Wandler der Spannungsmessvorrichtung vorgesehen ist. Alternativ oder ergänzend kann der zweiten Spannungsmesseinrichtung ein Umschalter zum wahlweisen Erfassen des Spannungsabfalls am zweiten Messwiderstandelement und der am Spannungsabgriffspunkt anliegenden Spannung zugeordnet sein, wobei der Umschalter insbesondere vor einem Analog-Digital-Wandler der zweiten Spannungsmesseinrichtung vorgesehen ist. Vorzugsweise ist der erste oder der zweite Referenzteilwiderstand ein hochgenauer Widerstand. Durch diese Anordnung kann, wie vorstehend beschrieben, der Referenzwiderstand bestimmt werden, wenn ein Referenzteilwiderstand bekannt ist. Des Weiteren kann zumindest ein Kalibrierfaktor des zweiten und/oder des dritten Analog/Digital-Wandlers bestimmt werden.

Die Umschalter sind vorzugsweise Multiplexer, die vor dem jeweiligen Analog/Digital-Wandler angeordnet sind. Der Umschalter kann auch für mehr als zwei Eingangssignale ausgelegt sein, beispielsweise für ein Spannungsabfallsignal und mehrere Sensorsignale, beispielsweise Temperatursignale. Unabhängig von der Anzahl der Sensoren sind somit nicht mehr als drei Analog/Digital-Wandler erforderlich bzw. die gesamte Bestimmung des Batteriezustandes kann mit drei Analog/Digital-Wandler erfolgen.

Um die Batteriespannung zweckmäßigerweise mit dem zweiten und dem dritten Analog/Digital-Wandler erfassen zu können, beispielsweise zur Bestimmung eines Kalibrierfaktors, kann ein Spannungsteiler für die Batteriespannung vorgesehen sein und der zweiten Spannungsmesseinrichtung ist ein Umschalter zum wahlweisen Erfassen des Spannungsabfalls am zweiten Messwiderstandelement und der am ersten Batteriesensoranschluss anliegenden Batteriespannung zugeordnet, wobei der Umschalter insbesondere vor einem Analog-Digital-Wandler der zweiten Spannungsmesseinrichtung vorgesehen ist.

Das erste und das zweite Messwiderstandelement können jeweils als Teile, insbesondere als Messzonen und/oder Messabschnitte, einer einstückigen Lastwiderstandseinheit ausgebildet sind.

Da die elektrischen Widerstände der Messwiderstände mit dem vorstehend bevorzugten, beschriebenen Verfahren bzw. dem vorstehend, bevorzugten beschriebenen Batteriesensor sehr genau bestimmt werden können, ist es nicht erforderlich, ein Material zu verwenden, das nur eine geringe Temperaturabhängigkeit und/oder ein geringes Alterungsverhalten hat. Die elektrischen Widerstände werden während des Betriebes permanent angepasst, so dass unabhängig vom Material der Messwiderstände eine sehr genaue Laststrommessung erfolgt.

Die Lastwiderstandseinheit, vorzugsweise bestehend aus der einstückigen Lastwiderstandseinheit, sowie den Batterieklemme und dem Masseanschluss kann auch einstückig, insbesondere als Stanzbiegeteil, ausgebildet sein.

Die gemessenen Spannungsabfälle, Spannungen und Signale können beispielswiese auch verstärkt werden. Hierzu können Verstärkerschaltungen vorgesehen sein, die insbesondere vor den Analog/Digital-Wandler und/oder vor den Umschalter vorgesehen sind. Die Verstärker bzw. die Verstärkungsfaktoren sind hierbei vorzugsweise so ausgebildet, dass die Größe der Eingangssignale für die Umschalter und/oder die Analog/Digital-Wandler bzw. die Signale für die Steuerung in einem ähnlichen Bereich liegen. Optional kann basierend auf Referenzstrom ein Fehlerwert für den Laststrom berechnet werden, um die Zuverlässigkeit des ermittelten Laststroms abzuschätzen.

Die Steuerung kann insbesondere Prozessormittel und Speichermittel aufweisen, wobei in den Speichermitteln Programmcode gespeichert ist, bei dessen Ausführung die Prozessormittel ein erfindungsgemäßes Verfahren ausführen bzw. sich entsprechend verhalten.

Weitere Merkmale und Vorteile wird der Fachmann den nachfolgend mit Bezug auf die beigefügte Zeichnung beschriebenen Ausführungsbeispielen entnehmen. Dabei zeigen in schematischer Darstellung:

Figur 1     einen Batteriesensor aus dem Stand der Technik;
Figur 2     einen Batteriesensor gemäß einer ersten Ausführungsform der Erfindung;
Figur 3:    einen Batteriesensor gemäß einer zweite Ausführungsform der Erfindung; und
Figur 4:    einen Batteriesensor gemäß einer dritten Ausführungsform der Erfindung.

Nachfolgend werden weitere Erklärungen zur Erfindung gegeben, wobei dies der Erklärung der Funktion dient.

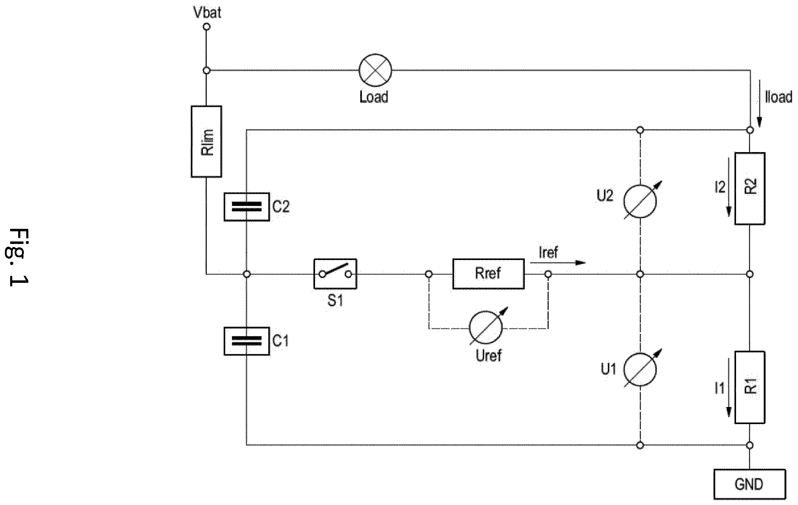

Hierzu wird zunächst auf Figur 1 Bezug genommen.

Figur 1 zeigt einen Batteriesensor aus Stand der Technik, mit dem sich ein Kalibrierverfahren durchführen lässt. Es benötigt aber drei A/D Wandler U1, U2 und Uref, von denen keiner eine Unterbrechungsfreie Messung von Vbat ermöglicht.

Die Messwiderstandsgruppe weist ein erstes Messwiderstandselement R1 und ein zweites Messwiderstandselement R2 auf, über welche ein zeitlich veränderlicher Laststrom Iload geleitet wird. Dieser Laststrom Iload stammt zunächst aus einer Batterie, welche spannungsmäßig als Vbat in Figur 1 eingezeichnet ist. Der Laststrom Iload fließt auch über eine allgemein als Load bezeichnet Last, welche hier lediglich schematisch dargestellt ist und typische elektrische Komponenten eines Kraftfahrzeugs wie beispielsweise einen Anlasser, ein Fahrzeuglicht oder elektronische Komponenten sowie auch einen Generator beinhalten kann.

Über dem ersten Messwiderstandselement R1 ist ein erster Spannungsmesser U1 angeordnet. Über dem zweiten Messwiderstandselement R2 ist ein zweiter Spannungsmesser U2 angeordnet. Diese sind dazu ausgebildet, jeweilige Spannungsabfälle über den beiden Messwiderständen R1, R2 bei jeweils durchfließendem Strom I1, I2 zu messen. Da die Widerstandselemente R1, R2 in Reihe angeordnet sind, entsprechen I1, I2 jeweils dem Laststrom Iload.

Als Stromquellen für einen Referenzstrom Iref dienen ein erster Kondensator C1 und ein zweiter Kondensator C2, welche über einen Vorwiderstand Rlim direkt aus der Fahrzeugbatterie geladen werden. Über den Verbraucher Load wird der Laststrom Iload aus der Batterie Vbat erzeugt, der über das Widerstandsnetzwerk der Messwiderstände R1, R2 zur Masse GND fließt.

Die beiden Kondensatoren C1, C2 sind über einen Schalter S1 und einen Referenzwiderstand Rref mit einem Punkt zwischen dem ersten Messwiderstand und dem zweiten Messwiderstand verbunden. An diesem Punkt sind auch die beiden Spannungsmesser U1, U2 angeschlossen. Über dem Referenzwiderstand Rref ist ein weiterer Spannungsmesser Uref angeordnet, welcher eine über dem Referenzwiderstand Rref bei durchfließendem Referenzstrom Iref abfallende Spannung misst.

Durch Schließen des Schalters S1 wird somit zusätzlich zum Laststrom Iload ein Referenzstrom Iref in das aus den Messwiderständen R1, R2 bestehende Widerstandsnetzwerk eingespeist, wobei sich der erste Kondensator C1 im Wesentlichen über den ersten Messwiderstand R1 entlädt, und der zweite Kondensator C2 sich im Wesentlichen über den zweiten Messwiderstand R2 entlädt. Hierdurch entstehen folglich zwei Kalibrierteilströme, nämlich ein erster Kalibrierteilstrom Iref,1 und ein zweiter Kalibrierteilstrom Iref,2, wobei der erste Kalibrierteilstrom Iref,1 durch den ersten Messwiderstand R1 fließt und der zweite Kalibrierteilstrom Iref,2 durch den zweiten Messwiderstand R2 fließt. Die beiden Kalibrierteilströme Iref,1 und Iref,2 tragen über den beiden Messwiderständen R1, R2 entgegengesetzte Vorzeichen, während ihre Summe Iref durch den Referenzwiderstand Rref fließt und wie bereits beschrieben über eine Spannungsmessung gemessen werden kann.

Die Spannungsmesser U1, U2 zur Messung der über den beiden Messwiderständen R1, R2 abfallenden Spannungen sind vorliegend nicht weiter im Detail ausgeführt. Die Spannungsmesser U1, U2 weisen typischerweise jeweils mindestens einen Verstärker auf, in der Regel mit variablem Verstärkungsfaktor, und je einen Analog-Digital-Wandler.

In Figur 1 nicht eingezeichnet ist ein Rechenwerk, beispielsweise eine elektronische Steuerungsvorrichtung, welche beispielsweise als Mikrocontroller ausgebildet sein kann. Eine solche elektronische Steuerungsvorrichtung kann beispielsweise Prozessormittel und Speichermittel aufweisen, wobei in den Speichermitteln Programmcode gespeichert ist, bei dessen Ausführung die Prozessormittel ein erfindungsgemäßes Verfahren ausführen. Insbesondere können die Prozessormittel dabei den Laststrom Iload gemäß den nachstehend genannten Formeln berechnen. Das Rechenwerk bzw. die elektronische Steuerungsvorrichtung kann bevorzugt auch eine Schnittstelle zum Einlesen der Spannungen U1, U2, Uref sowie eine Schnittstelle zum Steuern des Schalters S1 aufweisen.

Es sei erwähnt, dass anstelle der Kondensatoren C1, C2 jede beliebige andere Art von Stromquelle zum Einsatz kommen kann. Beispielsweise können DC/DC-Wandler, eine direkte Verbindung zum Pluspol einer Batterie (mit oder ohne Vorwiderstand Rlim), Längsregler, geregelte Präzisionsstromquellen (insbesondere mit Entfall der Iref-Messung über Rref) oder auch andere geeignete Ausführungen zum Einsatz kommen.

Bei geschlossenem Schalter S1, also bei angelegtem Referenzstrom ergibt sich das folgende lösbare Gleichungssystem für die Spannungen an den Messwiderstandselementen R1, R2:

$$U_m = \left( I_{load,i} + I_{ref,m} \right) * R_m * g_m$$

$$U_n = \left( I_{load,i} + I_{ref,n} \right) * R_n * g_n$$

Dabei sind

- $U_m$, $U_n$ die gemessenen Spannungsabfälle über je eines der Messwiderstandselemente, wobei m hier 1 sei und n 2,

- $R_m$, $R_n$ die (unbekannten) elektrischen Widerstände der Messwiderstandselemente, über die die Spannungsabfälle $U_m$, $U_n$ gemessen werden. Die Messwiderstandselemente können ihrerseits wieder aus weiteren, in Reihe oder parallel geschalteten Messwiderständen bestehen,

- $g_m$, $g_n$ die (fehlerbehafteten) Verstärkungsfaktoren der Messgeräte für die Spannungen $U_m$, $U_n$,

- $I_{load,i}$ der zu messende Laststrom oder ein Teil dieses Laststroms, der über die Messwiderstände der Messwiderstandsgruppe fließt, über die die Kalibrierspannungen $U_m$, $U_n$ gemessen werden,

- $I_{ref,m}$ und $I_{ref,n}$ angelegte Kalibrierteilströme, die über die Messwiderstände $R_m$, $R_n$ der Messwiderstandsgruppe fließen, über welchen die Kalibrierspannungen $U_m$, $U_n$ gemessen werden, wobei $I_{ref,m}$ und $I_{ref,n}$ in unterschiedliche Richtungen, bezogen auf $I_{load,i}$ fließen.

Insbesondere werden die Referenzteilströme bzw. wird der Referenzstrom periodisch angelegt, beispielsweise mit einer Periodendauer zwischen 10 ms und 100 ms für eine Dauer aus einer Zeitspanne zwischen 10 μs und 100 ps. Damit ergeben sich Zeiten, in denen Referenzströme oder Teile davon durch Messwiderstandselemente der Messwiderstandsgruppe fließen, also Zeiträume, und Zeiten, in denen keine Referenzströme durch die Messwiderstandsgruppe fließen. Zu diesen Zeiten, also außerhalb von Kalibrierzeiträumen, vereinfachen sich wenigstens ein Teil der Gleichungen des Gleichungssystems zu

$$U_m = I_{load,i} * R_m * g_m$$

$$U_n = I_{load,i} * R_n * g_n$$

$U_m$, $U_n$ sind hierbei die Spannungsabfälle des Laststroms über den Messwiderstandselementen R1, R2.
Alternativ können zu den Zeiten, in denen Referenzströme fließen, also innerhalb von Kalibrierzeiträumen, zeitlich veränderliche Referenzströme angelegt werden.
Zu den Zeiten, in denen keine Kalibrierströme durch das Netzwerk fließen, werden vorteilhaft Verhältnismäßigkeiten einzelnen Gleichungen des Gleichungssystems (bzw. zwischen gemessenen Spannungen $U_i$) gebildet, beispielsweise in einem Microcontroller, der Bestandteil einer Strommessvorrichtung oder mit dieser verbunden sein kann. Hierzu wird ein Korrekturfaktor $\alpha$ ermittelt, wobei gilt:

$$U_m = \alpha_{mn} * U_n$$

bzw.

$$U_m = \alpha_{mn} * I_{Load,i} * R_n * g_n$$

Beispielsweise können zu jeweils gleichen Zeiten t gemessene Spannungs-Wertepaare $U_n(t)$, $U_m(t)$ gespeichert werden. Diese gespeicherten Wertepaare können im Microcontroller mittels linearer Regression ausgewertet werden, um die Korrekturfaktoren m, o zu ermitteln.
Vorteilhaft kann nun bei eingeschalteten Kalibrierströmen durch Messung der Spannungen $U_m$, $U_n$

$$U_m = \alpha_{mn} * \left( I_{load,i} + I_{ref,m} \right) * R_n * g_n + o$$

$$U_n = \left( I_{Load,i} + I_{ref,n} \right) * R_n * g_n$$

der zu messende Teil des Laststroms wie folgt bestimmt werden:

$$\frac{U_m}{\alpha_{mn} * R_n * g_n} = I_{load,i} + I_{ref,m}$$

$$\frac{U_n}{R_n * g_n} = I_{load,i} + I_{ref,n}$$

$$\frac{U_n}{R_n * g_n} - \frac{U_m}{\alpha_{mn} * R_n * g_n} = I_{ref,n} - I_{ref,m}$$

$$\frac{U_n}{\left(I_{ref,n} - I_{ref,m}\right)} - \frac{U_m}{\alpha_{mn} * \left(I_{ref,n} - I_{ref,m}\right)} = R_n * g_n$$

$$I_{load,i} = \frac{U_n}{R_n * g_n} - I_{ref,n}$$

Die vorletzte Formel gibt eine Berechnungsvorschrift für den zweiten Betriebsparameter an.

In Zeiten, zu welchen kein Referenzstrom anliegt, gilt $I_{ref,m}$ = 0 und $I_{ref,n}$ = 0 und es kann die letzte Gleichung zur Bestimmung des zu messenden Laststroms $I_{load}$ benutzt werden.

Mit bekanntem $R_n$, $g_n$, $\alpha$, $\beta$ kann vorteilhafterweise folgende Gleichung zur Bestimmung von $I_{load}$ benutzt werden:

$$I_{load,i} = \frac{1}{2} * \left( \frac{U_m}{R_m * g_m} + \frac{U_n}{R_n * g_n} - I_{ref,m} - I_{ref,n} \right)$$

Aus der Summe beider Gleichungen lässt sich $I_{load}$ näherungsweise auch für die Zeiten zurückrechnen, in denen der Referenzstrom angeschaltet ist:

$$I_{load,i} = \frac{1}{2} * \left( \frac{U_m}{R_m * g_m} + \frac{U_n}{R_n * g_n} - I_{ref,m} - I_{ref,n} \right) = \frac{1}{2} * \left( \frac{U_m}{R_m * g_m} + \frac{U_n}{R_n * g_n} \pm \left\| I_{ref,m} \right| - \left| I_{ref,n} \right\| \right)$$

Dabei entsteht ein Fehler insbesondere dann, wenn sich die Ströme $I_{ref,m}$ und $I_{ref,n}$ stark unterscheiden.

Der Wert $I_{ref,m}$ -$I_{ref,n}$ ist dabei bekannt, er entspricht dem Referenzstrom, also der Summe der Kalibrierteilströme. Hierbei sind die unterschiedlichen Vorzeichen berücksichtigt.

Für die Ermittlung des Laststroms müssen grundsätzlich folgende Voraussetzungen erfüllt sein:

Erstens: Das Verhältnis $\alpha_{mn}$ von je zwei Produkten $R_n*g_n$, $R_m*g_m$ von Messwiderständen $R_n$ und $R_m$ und Verstärkungsfaktoren $g_n$, $g_m$ zueinander soll über einen gewissen Zeitraum im Wesentlichen stabil sein. Dieser gewisse Zeitraum soll deutlich länger sein als die Periodendauer, mit der die periodisch angelegten Kalibrierströme zu- und abgeschaltet werden bzw. periodisch verändert werden.

Zweitens: Der Wert des Referenzstroms $I_{ref}$ = $I_{ref,n}$ - $I_{ref,m}$ =|$I_{ref,n}$|+ |$I_{ref,m}$| soll zu mindestens einem Zeitpunkt, zu dem $U_n$ und $U_m$ bei angelegtem Referenzstrom gemessen werden, genau bekannt sein.

Es sei nun darauf hingewiesen, dass

1) der Spannungsabfall in einem Messwiderstand erhöht, der andere reduziert wird, und

2) aus der Differenz beider Messspannungen der Widerstand berechnet wird.

Hierdurch ist eine zeitaktuelle Messung des Widerstandes möglich. Dieser muss daher nicht dauerhaft konstant sein. Kostengünstigere Materialien können zum Einsatz kommen.

Durch die beschriebene Anordnung bzw. das beschriebene Verfahren ist es möglich, praktisch ohne Vorkenntnis des Widerstandsnetzwerks bzw. der Messwiderstandsgruppe und der relativen Genauigkeit der Messgeräte, mit denen die Spannungen gemessen werden, den Laststrom zu bestimmen. Dadurch kann trotz des kostengünstigeren Materials sogar eine höhere Genauigkeit der Strommessung erreicht werden, als bei Ausführungen gemäß dem Stand der Technik. Bisher geht nämlich im Wesentlichen sowohl die Toleranz des Widerstandswerts des Messwiderstands als auch die Toleranz der Spannungs-Messvorrichtung für den Spannungsabfall in die Toleranz des gemessenen Stromwerts ein.

Mit der beschriebenen Vorrichtung bzw. Anordnung ist typischerweise lediglich eine genaue Kenntnis von $I_{ref}$

zu einem Zeitpunkt erforderlich. Zudem werden praktisch keine Anforderungen an die Qualität der Stromquelle für $I_{ref}$ gestellt. Lediglich eine genaue Messung von $I_{ref}$ ist typischerweise nötig. Dies ist beispielsweise mit einem entsprechend genauen Referenzwiderstand $R_{ref}$ und einer genauen Messung des Spannungsabfalls über $R_{ref}$ einfach zu erreichen. $R_{ref}$ kann nämlich, anders als der Messwiderstand für den Laststrom, einen hohen Widerstand von z.B. 1 Ohm haben, der nur für kleine Referenzströme und nicht für hohe Lastströme ausgelegt zu werden braucht. Durch den entsprechend hoch gewählten Wert von $R_{ref}$ kann auch der Spannungsabfall $I_{ref} * R_{ref}$ bequem gemessen werden, da z. B. kein aufwändiger Verstärker erforderlich ist.

Nicht gezeigt ist hier, dass zusätzlich die Batteriespannung Vbat erfasst wird.

Aus der Batteriespannung Vbat, dem Laststrom Iload sowie optional einer erfassten Batterietemperatur kann der Batteriezustand der Batterie ermittelt werden.

Für die Bestimmung der elektrischen Widerstände der Widerstandselemente R1, R2 wird aber die Messung des Laststroms Iload unterbrochen. Beispielsweise kann der Messwert von $I_{load}$ für den Kalibrierzeitpunkt aus Mittelwerten von Messwerten vor dem Kalibrierzeitpunkt und Messwerten nach dem Kalibrierzeitpunkt gebildet werden. Alternativ kann eine Entscheidung getroffen werden, ob der fehlerbehaftete Messwert benutzt oder ein Ersatzwert gebildet wird. Die Entscheidung kann z. B. auf Basis eines aktuellen Wertes des "Symmetriefaktors" m im Vergleich zu früheren Werten von m getroffen werden. Die Entscheidung kann aber auch davon abhängig gemacht werden, wie groß das Verhältnis des Fehlers im Vergleich zum anliegenden Laststrom ist.

Für eine zuverlässige Bestimmung des Batteriezustandes ist aber eine unterbrechungsfreie Strommessung erforderlich, um stets genaue Werte des Laststrom Iload zu erhalten.

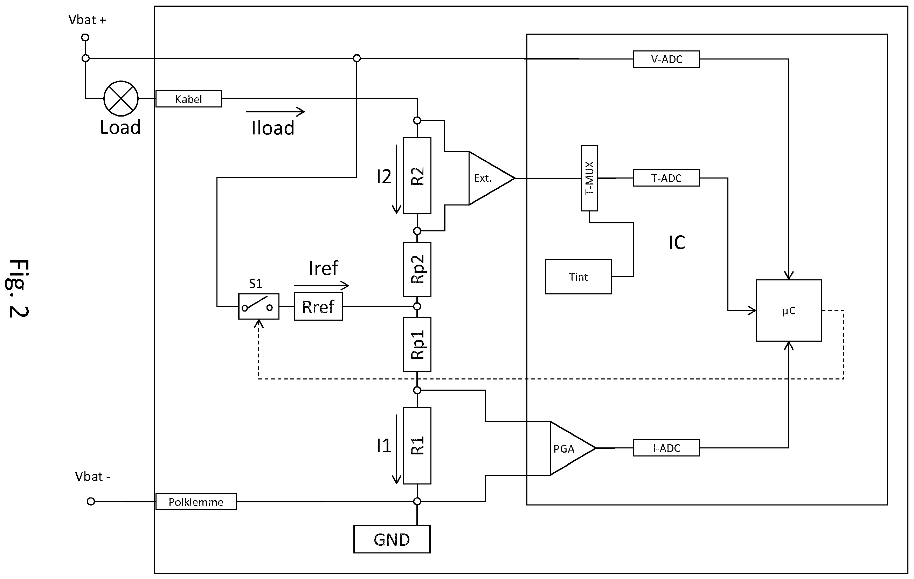

Figur 2 zeigt einen erfindungsgemäßen Batteriesensor.

Der Batteriesensor hat eine Strommessvorrichtung, eine Spannungsmessvorrichtung eine Referenzstromschaltung sowie eine Steuerung pC.

Die Spannungsmessvorrichtung weist einen Analog/Digital-Wandler V-ADC auf, der einerseits mit einem ersten Batteriesensoranschluss Vbat+ verbunden ist, der hier durch den Plus-Pol der Batterie gebildet ist. Des Weiteren ist der Analog/Digital-Wandler V-ADC mit der Steuerung µC verbunden.

Die Strommessvorrichtung weist ein erstes und ein zweites Messwiderstandselement R1, R2 auf, welchen jeweils eine Spannungsmesseinrichtung zugeordnet ist. Die erste Spannungsmesseinrichtung weist einen Verstärker PGA sowie einen ersten Analog/Digital-Wandler I-ADC auf, die zweite Spannungsmesseinrichtung einen Verstärker Ext. sowie einen zweiten Analog/Digital-Wandler T-ADC. Die Analog/Digital-Wandler I-ADC, T-ADC sind jeweils mit einem Eingang einer Steuerung µC verbunden. Die Messwiderstandselemente R1, R2 sind zwischen einem Laststromanschluss und einem zweiten Batteriesensoranschluss Vbat- in Reihe geschaltet.

Zwischen dem Verstärker Ext. und dem zweiten Analog/Digital-Wandler T-ADC ist ein Umschalter T-MUX vorgesehen, an den, neben dem Verstärker Ext. ein Temperatursensor Tint angeschlossen ist. Mit dem Umschalter kann entweder das Signal des Verstärkers Ext. oder das Signal des Temperatursensors an den zweiten Analog/Digital-Wandler ausgegeben werden.

Des Weiteren ist eine Referenzstromschaltung vorgesehen, die einen Schalter S1 sowie einen Referenzwiderstand Rref aufweist. Der Schalter S1 ist in Reihe mit dem Referenzwiderstand angeordnet. Die Referenzstromschaltung ist direkt mit einem ersten Batteriesensoranschluss Vbat+ verbunden. Der Referenzstrom Iref ist also direkt von der Batteriespannung abhängig. Des Weiteren ist die Referenzstromschaltung mit einem Kontaktpunkt zwischen den beiden in Reihe angeordneten Messwiderstandelementen R1, R2 verbunden.

Zwischen dem Kontaktpunkt und den Messwiderstandselementen sind zusätzliche Widerstände Rp2 und Rp1 dargestellt, die beispielsweise durch Leitungswiderstände gebildet sein können.

Durch Schließen des Schalters S1, der beispielsweisen von der Steuerung µC gesteuert wird, wird somit zusätzlich zum Laststrom Iload der Referenzstrom Iref in die Widerstandselemente R1, R2 eingespeist, wobei sich der durch den ersten Widerstand R1 fließenden Strom I1 im Wesentlichen aus dem durch den zweiten Widerstand R2 fließenden Strom I2 und dem Referenzstrom Iref zusammensetzt.

Das Verfahren zum Betrieb bzw. zur Nutzung des Stromsensors weist vorzugsweise drei Messintervalle auf, deren Reihenfolge, Häufigkeit und Dauer, wie nachfolgend erläutert wird, beliebig geändert werden kann.

In einem ersten Messintervall wird zunächst das Verhältnis der Messwiderstände ermittelt, das heißt, die Korrekturfaktoren α, β. In diesem Messintervall ist der Schalter S1 geöffnet. Der erste Analog-Digital-Wandler I-ADC ermittelt den vom ersten Verstärker PGA verstärkten Spannungsabfall U1=R1*I1 über das erste Messwiderstandselement R1 und der zweite Analog-Digital-Wandler T-ADC ermittelt den vom zweiten Verstärker Ext verstärkten Spannungsabfall U2=R2*I2 über das zweite Messwiderstandselement R2.

Zugleich wird die Batteriespannung Vbat+ vom dritten Analog-Digital-Wandler V-ADC ermittelt.

Die Batteriespannung Vbat+ und der aus den Spannungsabfällen U1 und U2 ermittelten Laststrom Iload werden in der Steuerung zur Ermittlung des Batteriezustandes verwendet.

Während dieses ersten Messintervalls berechnet der Mikrocontroller zudem, beispielsweise mittels linearer Regression, aus wenigstens einem Messpaar das Verhältnis zwischen der ersten verstärkten Messspannung U1 und der zweiten verstärkten Messspannung U2. Dabei wird beispielsweise ein Verhältnis $\alpha$ oder vorzugsweise ein Verhältnis $\alpha$ sowie ein Offset $\beta$ nach folgender Gleichung ermittelt: U1 = $\alpha_{12}$*U2 + $\beta_{12}$. Ein Messpaar besteht insbesondere aus der Messung der ersten verstärkten Messspannung und der zweiten verstärkten Messspannung.

In einem zweiten Messintervall wird der Schalter S1 geschlossen und es fließt ein Referenzstrom Iref über den Referenzwiderstand Rref. Während dieses Messintervalls misst der erste Analog-Digital-Wandler I-ADC den vom ersten Verstärker PGA verstärkten Spannungsabfall U1 und der zweite Analog-Digital-Wandler T-ADC misst den vom zweiten Verstärker Ext verstärkten Spannungsabfall U2.

Zugleich wird die Batteriespannung Vbat vom dritten Analog-Digital-Wandler V-ADC ermittelt.

Anhand des ermittelten ersten Betriebsparameters und der gemessenen, verstärkten Spannung U2 ist die verstärkte Spannung U1 beispielsweise nach folgender Gleichung schätzbar:

$$\text{U1est} = \alpha_{12} * \text{U2} + \beta_{12}.$$

Anschließend ist eine Differenz der gemessenen Spannung U1 und der Schätzung der Spannung U1 ermittelbar aus:

$$\text{Udiff} = \text{U1} - \text{U1est}.$$

Zusätzlich ist der Referenzstrom anhand des bekannten Widerstandswerts Rref und der gemessenen Batteriespannung Vbat beispielsweise nach folgender Gleichung ermittelbar:

$$\text{Iref} = \text{Vbat}/\text{Rref}.$$

Hierzu sei nochmals darauf hingewiesen, dass die elektrischen Widerstände von R1 und Rp1 sowie auch Rp2 und R2 wesentlich kleiner sind als der elektrische Widerstand von Rref. Die elektrischen Widerstände von R1, Rp1, R2, Rp2 liegen in der Größenordnung von 0.05..0.1 mOhm. Der elektrische Widerstand von Rref liegt in der Größenordnung 1Ohm...10Ohm, um den Kalibrierstrom in einem Bereich von ca. 1A zu halten. Damit werden R1 und Rp1 gegen Rref vernachlässigbar klein(<0.1%), so dass die elektrischen Widerstände von R1 und rp1 für die Berechnung des Referenzstroms Iref vernachlässigt werden können.

Ausgehend von der Differenz der gemessenen Spannung U1 und der Schätzung der Spannung U1 sowie dem Referenzstrom kann der genaue elektrische Widerstand von R1 ermittelt werden, aus sowie über die ermittelten Korrekturfaktoren der elektrische Widerstand von R2, entsprechend der Formeln:

$$\text{R1} = \text{Udiff}/\text{Iref}; \text{ und } \text{R22} = \text{Cal1} * \alpha_{12} + \beta.$$

Die elektrischen Widerstände können nachfolgend für die Bestimmung des Laststroms aus I1=U1/R1 bzw. I2=U2/R2 verwendet werden.

Nachfolgend sei noch eine Herleitung für die oben genannten Formeln gegeben. Bezüglich der Bedeutung der einzelnen Variablen sei auf die obige Beschreibung verwiesen.

$$\left| I_{ref,1} \right| + \left| I_{ref,2} \right| = I_{ref}$$

$$I1 = I_{load} + \left| I_{ref,1} \right|$$

$$I2 = I_{load} - \left| I_{ref,2} \right|$$

$$U1 = R1 * g_1 * \left( I_{load} + \left| I_{ref,1} \right| \right)$$

$$U2 = R2 * g_2 * \left( I_{load} - \left| I_{ref,2} \right| \right)$$

$$\alpha * R1 * g_1 = R2 * g_2$$

$$U2 = \alpha * R1 * g_1 * \left( I_{load} - \left| I_{ref,2} \right| \right)$$

$$U1 - \frac{1}{\alpha} * U2 = R1 * g_1 * \left( \left| I_{ref,1} \right| + \left| I_{ref,2} \right| \right)$$

$$R1 * g_1 = \frac{U1 - \frac{1}{\alpha} * U2}{I_{ref}}$$

$$R2 * g_2 = \alpha * R1 * g_1$$

Da weiterhin die Batteriespannung Vbat+ über den dritten Analog/Digital-Wandler V-ADC sowie der Laststrom Iload über die Spannungsabfälle an R1 und R2 ermittelt werden, erfolgt weiterhin eine unterbrechungsfreie Batteriezustandsermittlung.

In einem dritten Messintervall ermittelt der zweite Analog-Digital-Wandler T-ADC über eine entsprechende Stellung des ersten Multiplexers T-MUX die Spannung des internen Temperatursensors Tint. Während des dritten Messintervalls ist vorteilhafterweise der Schalter S1 geöffnet, da auf diese Weise sichergestellt ist, dass kein Referenzstrom Iref fließt und dementsprechend keine Messung von Iref notwendig ist.

Über den ersten Analog-Digital-Wandler I-ADC wird während dieses Messintervalls weiterhin der Spannungsabfall an R1 erfasst, aus dem der Strom I1, der dem Laststrom Iload entspricht, ermittelt werden kann.

Es werden also weiterhin die Batteriespannung Vbat+ über den dritten Analog/Digital-Wandler V-ADC und der Laststrom Iload über den ersten Analog/Digital-Wandler unterbrechungsfrei erfasst. Zusätzlich wird die Temperatur über den zweiten Analog/Digital-Wandler erfasst.

Die Temperatur ändert sich nur relativ langsam. Ebenfalls ändern sich die Korrekturfaktoren $\alpha$, $\beta$ nur langsam. Das erste und das dritte Messintervall können also weniger häufig ausgeführt werden oder gegebenenfalls kürzer sein als das zweite Messintervall.

In jedem Messintervall erfolgt aber eine unterbrechungsfreie Bestimmung des Laststroms Iload sowie der Batteriespannung Vbat+.

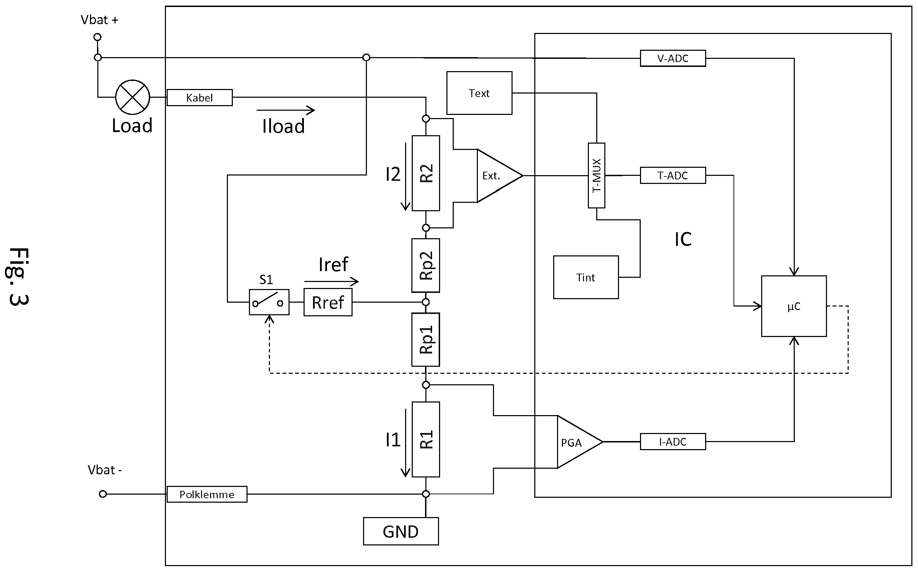

Figur 3 zeigt eine Messwiderstandsgruppe mit Messschaltung gemäß einem zweiten Ausführungsbeispiel, bei dem der erste Multiplexer T-MUX einen dritten Eingang aufweist. Mittels des dritten Eingangs kann die Auswahl eines analogen Temperatursignals von beispielsweise einem zusätzlichen externen Temperatursensor Text erfolgen.

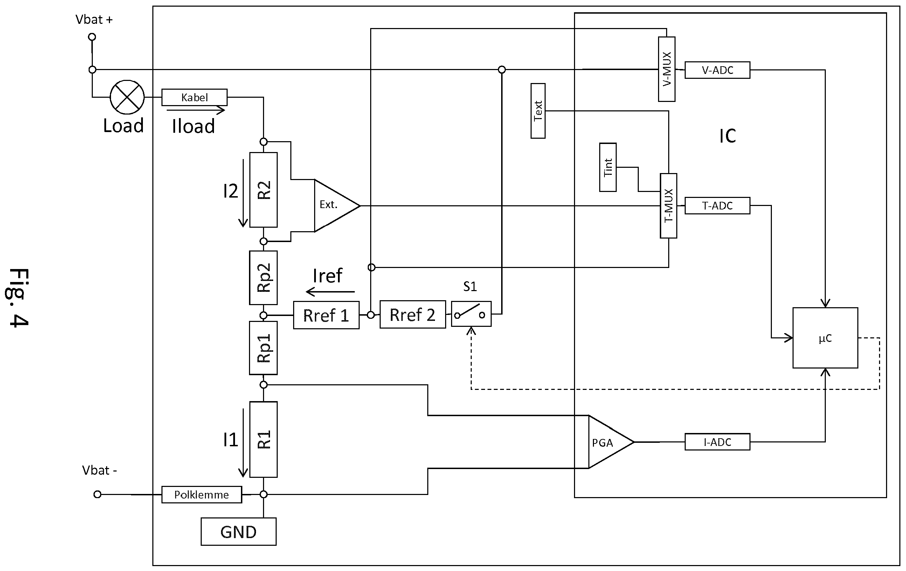

Figur 4 zeigt eine Messwiderstandsgruppe mit Messschaltung gemäß einem dritten Ausführungsbeispiel, bei dem der Referenzwiderstand einen ersten Referenzteilwiderstand Rref 1 und einen zweiten Referenzteilwiderstand Rref 2 aufweist. Eine Spannung an einem Spannungsabgriffspunkt zwischen dem ersten Referenzteilwiderstand Rref 1 und dem zweiten Referenzteilwiderstand Rref 2 wird einem vierten Eingang des zweiten Multiplexers T-ADC sowie einem weiteren Eingang des dritten Multiplexer V-MUX zugeführt, welcher dem dritten Analog-Digital-Wandler V-ADC vorgeschaltet ist.

Vorzugsweise ist nur einer der Referenzteilwiderstände Rref1, Rref2, nämlich der Referenzteilwiderstand Rref 1 ein hochgenauer Widerstand mit einer geringen Temperaturabhängigkeit und einer geringen alterungsbedingten Drift. Der elektrische Widerstand von Rref1 ist zudem deutlich geringer als der von Rref2, so dass der hochgenaue Widerstand deutlich kleiner und somit kostengünstiger ist.

In dieser Ausführungsform ist es aber erforderlich, den genauen elektrischen Widerstand von Rref2 zu bestimmen. Dies erfolgt in einem vierten Messintervall, indem über eine entsprechende Stellung des zweiten Multiplexers T-MUX die Spannung an dem Spannungsabgriffspunkt zwischen Rref 1 und Rref2 mit dem zweiten Analog-Digital-Wandler T-ADC ermittelt wird. Während des vierten Messintervalls ist der Schalter S1 geschlossen.

Weiterhin wird über eine entsprechende Stellung des Multiplexers V-MUX die Batteriespannung Vbat+ mit dem dritten Analog-Digital-Wandler V-ADC und der Batteriestrom über den ersten Analog/Digital-Wandler I-ADC und den zweiten Analog/Digital-Wandler T-ADC ermittelt.

Der Mikrocontroller berechnet das Teilerverhältnis zwischen Rref1 und der Summe aus Rref1 und Rref2 anhand des Verhältnisses der Spannungspotentiale, welche von dem dritten Analog-Digital-Wandler V-ADC und dem zweiten Analog-Digital-Wandler T-ADC ermittelt und dem Mikrocontroller zugeführt werden.

Aus dem ermittelten Teilerverhältnis und aus dem bekannten elektrischen Widerstand des ersten Referenzteilwiderstandes Rref1 kann ein genauer Gesamtwiderstandswert für den ganzen Referenzwiderstand (Rref1 + Rref2) ermittelt werden.

Mit diesem Wert kann in einem nachfolgenden zweiten Messintervall eine genauere Bestimmung des Referenzstroms und somit eine genauere Bestimmung des elektrischen Widerstandes des ersten Messwiderstandelements R1 erfolgen.

In einem fünften Messintervall kann eine gegenseitige Kalibrierung des ersten des zweiten und des dritten Analog/Digital-Wandlers erfolgen, indem wenigstens zwei Analog-Digital-Wandler dieselbe physikalische Messgröße ermitteln und wenigstens ein Kalibrierfaktor anhand der Abweichung der ermittelten physikalischen Messgröße bestimmt wird.

Beispielsweise wird bei geschlossenem Schalter S1, also bei angelegtem Referenzstrom Iref, der dritte Multiplexer V-MUX und der zweite Multiplexer T-MUX so geschaltet, dass der dritte Analog-Digital-Wandler V-ADC und der zweite Analog-Digital-Wandler T-ADC jeweils die Spannung am Spannungsabgriffspunkt zwischen dem Referenzteilwiderstand Rref1 und dem Referenzteilwiderstand Rref2 ermitteln. Anhand der jeweils ermittelten Spannungen wird ein Kalibrierfaktor für den zweiten Analog-Digital-Wandler T-ADC ermittelt.

Alternativ werden in einem fünften Messintervall, in welchem der Schalter S1 geöffnet ist, der dritte Multiplexer V-MUX und der zweite Multiplexer T-MUX so geschaltet, so dass der dritte Analog-Digital-Wandler V-ADC und der zweite Analog-Digital-Wandler T-ADC jeweils das Spannungspotential der Batterie Vbat+ erfassen. Vorzugsweise teilt ein Spannungsteiler das Spannungspotential der Batterie Vbat+ mit einem bekannten Teilerverhältnis, um das Spannungspotential der Batterie Vbat+ auf den Messbereich des Analog-Digital-Wandlers T-ADC anzupassen. Anhand des jeweils ermittelten Spannungspotentials Vbat wird ein Kalibrierfaktor für den zweiten Analog-Digital-Wandler T-ADC ermittelt. Bei dieser alternativen vorteilhaften Ausgestaltung muss die Messung des Spannungspotentials der Batterie nicht unterbrochen werden.

Die vorstehend beschriebenen Schritte des Verfahrens können in der angegebenen Reihenfolge ausgeführt werden. Sie können jedoch auch in einer anderen Reihenfolge ausgeführt werden. Das erfindungsgemäße Verfahren kann in einer seiner Ausführungen, beispielsweise mit einer bestimmten Zusammenstellung von Schritten, in der Weise ausgeführt werden, dass keine weiteren Schritte ausgeführt werden. Es können jedoch grundsätzlich auch weitere Schritte ausgeführt werden, auch solche welche nicht erwähnt sind.

Beliebige Teilmengen der gezeigten Schaltungen können beispielsweise diskret auf einer Leiterplatte bestückt werden oder in einem Halbleiterbaustein integriert werden. Zusätzlich kann die diskrete Schaltung oder der Halbleiterbaustein weitere Vorrichtungen, beispielsweise Temperatursensoren, insbesondere zur Temperaturmessung, mindestens einen der Widerstände Rref, R1, R2,..., Rn, Spannungssensoren, insbesondere zur Messung von Batteriespannungen, Kommunikationsschnittstellen, Vorrichtungen zur Regelung der Stromquellen C1, C2, weitere Stromquellen, Taktgeber, flüchtige und/oder nichtflüchtige Datenspeicher, insbesondere zur Speicherung von Kalibrierdaten der Strommessvorrichtung, beispielsweise ein im Fertigungs-Endtest ermittelter Wert von Rref oder ein Temperaturkoeffizient von Rref, Mikroprozessoren, insbesondere zur Berechnung von physikalischen Größen der Batterie oder zur Berechnung von Temperaturmodellen, insbesondere zur Berechnung der Batterietemperatur, der Umgebungstemperatur der Vorrichtung oder zur Berechnung einer Temperatur eines oder mehrerer der verwendeten Widerstände Rref, R1,..., Rz aufweisen.

Die gesamte Anordnung oder eine beliebige Teilmenge der Vorrichtung kann beispielsweise in ein Kunststoff- oder Metallgehäuse mit oder ohne integriertem Stecker eingebaut werden, oder kann mit einem Kunststoff umspritzt werden.

Die gesamte Anordnung oder eine beliebige Teilmenge der genannten Vorrichtungen, insbesondere die Messwiderstände bzw. Shunt-Widerstände R1,..., Rz können in eine Batterie-Polklemme, in einen Kabelschuh, in ein Batteriekabel oder in eine Batterie integriert werden.

Die Messwiderstandselemente R1, R2 können Teil einer einstückigen Lastwiderstandseinheit sein, beispielsweise Zonen auf einem Lastwiderstand.

Die Lastwiderstandseinheit bestehend aus der einstückigen Lastwiderstand, sowie den Batterieklemme und dem Masseanschluss kann auch einstückig, insbesondere als Stanzbiegeteil, ausgebildet sein.

Die Schaltung kann darüber hinaus einen oder mehrere Chopper für die an den Widerständen Rref, R1,..., Rz abgegriffenen Spannungen enthalten.

Die Schaltung kann darüber hinaus ein oder mehrere Sample-and-Hold-Glieder oder andere analoge Puffer für an den Widerständen Rref, R1,..., Rz abgegriffene Spannungen oder dort abgegriffene oder verstärkte Spannungen enthalten.

Die zur Anmeldung gehörigen Ansprüche stellen keinen Verzicht auf die Erzielung weitergehenden Schutzes dar.

Sofern sich im Laufe des Verfahrens herausstellt, dass ein Merkmal oder eine Gruppe von Merkmalen nicht zwingend nötig ist, so wird anmelderseitig bereits jetzt eine Formulierung zumindest eines unabhängigen Anspruchs angestrebt, welcher das Merkmal oder die Gruppe von Merkmalen nicht mehr aufweist. Hierbei kann es sich beispielsweise um eine Unterkombination eines am Anmeldetag vorliegenden Anspruchs oder um eine durch weitere Merkmale eingeschränkte Unterkombination eines am Anmeldetag vorliegenden Anspruchs handeln. Derartige neu zu formulierende Ansprüche oder Merkmalskombinationen sind als von der Offenbarung dieser Anmeldung mit abgedeckt zu verstehen.

Zum Zweck der besseren Lesbarkeit werden in den Ansprüchen einige Bezugszeichen verkürzt wiedergegeben. So wird der erste Betriebsparameter mit $\alpha$ bezeichnet.

**Patentansprüche**

1. Verfahren zum Betrieb eines Batteriesensors, umfassend zumindest

   - einen ersten Batteriesensoranschluss (Vbat+) und einen zweiten Batteriesensoranschluss (Vbat-),
   - eine Strommessvorrichtung zur Erfassung eines Laststroms (Iload), mit einem ersten Messwiderstandselement (R1) und einem zweiten Messwiderstandselement (R2), wobei das erste und das zweite Messwiderstandselement (R1, R2) zwischen einem Laststromanschluss und dem zweiten Batteriesensoranschluss (Vbat-) in Reihe geschaltet sind,
   - eine Referenzstromschaltung mit zumindest einem Referenzwiderstand (Rref, Rref1, Rref2), wobei der Referenzwiderstand (Rref, Rref1, Rref2)mit dem ersten Batteriesensoranschluss (Vbat+) und einem zwischen den Messwiderstandselementen (R1, R2) vorgesehenen Kontaktpunkt kontaktiert ist,
   wobei der elektrische Widerstand des ersten Messwiderstandselements (R1) bestimmt wird durch
   - Zuschalten eines Referenzstroms (Iref) und Erfassen der jeweiligen resultierenden Spannungsabfälle (U1, U2) über das erste und das zweite Messwiderstandselement (R1, R2) sowie der Batteriespannung (Vbat+),
   - Bestimmen des Referenzstroms (Iref) aus dem Quotienten der Batteriespannung (Vbat+) und dem elektrischen Widerstand des Referenzwiderstandes (Rref),
   **gekennzeichnet durch**
   - Bestimmen des elektrischen Widerstands des ersten Messwiderstandselements (R1) aus den erfassten Spannungsabfällen (U1, U2), dem Referenzstrom (Iref) und zumindest einem Korrekturfaktor ($\alpha$, $\beta$), der das Verhältnis zwischen dem elektrischen Widerstand des ersten Messwiderstandselements (R1) und dem elektrischen Widerstand des zweiten Messwiderstandselements (R2) charakterisiert.

2. Verfahren nach Anspruch 1, **dadurch gekennzeichnet, dass** der Laststrom (Iload) bestimmt wird durch

   - Abschalten des Referenzstroms (Iref),
   - Erfassen zumindest des Spannungsabfalls (U1) über das erste Messwiderstandselement (R1)

3. Verfahren nach Anspruch 2, **dadurch gekennzeichnet, dass** ein Batteriezustand ermittelt wird durch

   - Erfassen der Batteriespannung (Vbat+)
   - Bestimmen des Laststroms (Iload) aus dem Spannungsabfall (U1) über das erste Messwiderstandselement (R1), und
   - Erfassen eines Batterieparameters mit einem Sensor (Tint, Text), insbesondere Erfassen einer Temperatur mit einem Temperatursensor.

4. Verfahren nach einem der Ansprüche 1 bis 3, **dadurch gekennzeichnet, dass** der zumindest eine Korrekturfaktor ($\alpha$, $\beta$) aus den jeweiligen Spannungsabfällen (U1, U2) und/oder den Verläufen der Spannungsabfälle (U1, U2) des Laststroms (Iload) über das erste und das zweite Messwiderstandselement (R1, R2) bei abgeschaltetem Referenzstrom (Iref) bestimmt wird.

5. Verfahren nach Anspruch 3, **dadurch gekennzeichnet, dass**

- die Bestimmung des elektrischen Widerstandes des ersten Messwiderstandselement (R1),
- die Bestimmung des Laststroms (Iload),
- die Ermittlung des Batteriezustandes und/oder
- die Erfassung des Batterieparameters mit dem Sensor (Tint, Text),

wechselweise, insbesondere periodisch, wiederholt werden.

6. Verfahren nach einem der Ansprüche 1 und 2, **dadurch gekennzeichnet, dass** der Referenzwiderstand (Rref) wenigstens einen ersten Referenzteilwiderstand (Rref 1) und einen zweiten Referenzteilwiderstand (Rref 2) aufweist, und eine Bestimmung des Referenzwiderstandes (Rref) erfolgt durch

   - Zuschalten des Referenzstroms (Iref) in die Messwiderstandsgruppe aus wenigstens dem ersten Referenzteilwiderstand (Rref 1) und dem zweiten Referenzteilwiderstand (Rref 2),
   - Erfassen einer Spannung an einem Spannungsabgriffspunkt zwischen den Referenzteilwiderständen (Rref1, Rref2),
   - Erfassen der Batteriespannung (Vbat+),
   - Bestimmen des Teilerverhältnisses aus der erfassten Spannung und der erfassten Batteriespannung (Vbat+),
   - Bestimmen des elektrischen Widerstandes des zweiten Referenzteilwiderstandes (Rref 2) aus dem Teilerverhältnis und dem bekannten elektrischen Widerstand des ersten Referenzteilwiderstandes (Rref 1).

7. Verfahren nach einem der Ansprüche 3 und 5, **dadurch gekennzeichnet, dass** die Erfassung der Spannung (Vbat+), der Spannungsabfälle (U1, U2) und die Erfassung des Batterieparameters mit drei Analog/Digital-Wandlern erfolgt, wobei ein erster Analog/Digital-Wandler (I-ADC) zur Erfassung des Spannungsabfalls (U1) über das erste Messwiderstandselement (R1), ein zweiter Analog/Digital-Wandler (T-ADC) zur wahlweisen Erfassung des Spannungsabfalls (U2) über das zweite Messwiderstandselement (R2) oder des Batterieparameters des einen Sensors (Tint, Text) und ein dritter Analog/Digital-Wandler (V-ADC) zur Erfassung der Batteriespannung (Vbat+) vorgesehen ist.

8. Verfahren nach Anspruch 7, **dadurch gekennzeichnet, dass** zeitweise eine Bestimmung eines Kalibrierfaktors des zweiten oder des dritten Analog/Digital-Wandlers erfolgt, durch Anlegen der gleichen Batteriespannung (Vbat+), des gleichen Spannungsabfalls und/oder des gleichen Parameters eines Sensors an den zweiten und den dritten Analog/Digital-Wandler .

9. Verfahren nach Anspruch 8, **dadurch gekennzeichnet, dass** mit dem zweiten Analog/Digital-Wandler (T-ADC) und dem dritten Analog/Digital-Wandler (V-ADC) gleichzeitig die Batteriespannung (Vbat+) erfasst wird.

10. Verfahren nach Anspruch 8, **dadurch gekennzeichnet, dass** mit dem den zweiten Analog/Digital-Wandler (T-ADC) und dem dritten Analog/Digital-Wandler (V-ADC) jeweils eine an einem Spannungsabgriffspunkt zwischen einem ersten Referenzteilwiderstand (Rref 1) und einem zweiten Referenzteilwiderstand (Rref 2) des Referenzwiderstandes (Rref) anliegende Spannung erfasst wird.

11. Batteriesensor zur Bestimmung eines Batteriezustandes einer Batterie, insbesondere einer Fahrzeugbatterie, umfassend zumindest

   - einen ersten Batteriesensoranschluss (Vbat+) und einen zweiten Batteriesensoranschluss (Vbat-),
   - eine Spannungsmessvorrichtung zur Erfassung der elektrischen Spannung (Vbat+) am ersten Batteriesensoranschluss,
   - eine Strommessvorrichtung zur Erfassung des Laststroms (Iload), mit einem ersten Messwiderstandselement (R1) und einem zweiten Messwiderstandselement (R2), wobei das erste und das zweite Messwiderstandselement (R1, R2) zwischen dem Laststromanschluss und dem zweiten Batteriesensoranschluss (Vbat-) in Reihe geschaltet sind, und wobei eine erste und eine zweite Spannungsmesseinrichtung zur Erfassung jeweils des Spannungsabfalls (U1, U2) über das erste und das zweite Messwiderstandselement (R1, R2) vorgesehen sind,
   - eine Referenzstromschaltung mit zumindest einem Referenzwiderstand (Rref, Rref1, Rref2), wobei der Referenzwiderstand (Rref, Rref1, Rref2) mit dem ersten Batteriesensoranschluss (Vbat+) und einem zwischen den Messwiderstandselementen (R1, R2) vorgesehenen Kontaktpunkt kontaktiert ist,
   **gekennzeichnet durch**
   - eine Steuerung ($\mu$C) zur Ermittlung des Laststroms (Iload) und des Batteriezustandes, mit einem Verfahren nach einem der vorhergehenden Ansprüche.

**12.** Batteriesensor nach Anspruch 11, **dadurch gekennzeichnet, dass** die Spannungsmessvorrichtung und/oder die erste und die zweite Spannungsmesseinrichtungen einen Analog-Digital-Wandler (V-ADC, T-ADC, I-ADC) aufweisen.

**13.** Batteriesensor nach einem der Ansprüche 11 und 12, **dadurch gekennzeichnet, dass** zumindest ein Sensor (Tint, Text) zur Erfassung eines Batterieparameters vorgesehen ist und dass der zweiten Spannungsmesseinrichtung ein Umschalter, insbesondere einen Multiplexer (T-MUX), zum Umschalten zwischen einem Signal der zweiten Spannungsmesseinrichtung und einem Signal des Sensors (Tint, Text) zugeordnet ist, wobei der Umschalter insbesondere vor einem Analog-Digital-Wandler (T-ADC) der zweiten Spannungsmesseinrichtung vorgesehen ist.

**14.** Batteriesensor nach einem der Ansprüche 11 bis 12, **dadurch gekennzeichnet, dass** der Referenzwiderstand (Rref) zumindest zwei in Reihe angeordnete Referenzteilwiderstände (Rref1, Rref2) aufweist, wobei zwischen den Referenzteilwiderständen (Rref1, Rref2) ein Spannungsabgriffspunkt vorgesehen ist, wobei der Spannungsmessvorrichtung ein Umschalter (V-Mux) zum wahlweisen Erfassen der Batteriespannung (Vbat+) oder der am Spannungsabgriffspunkt anliegenden Spannung zugeordnet ist, wobei der Umschalter insbesondere vor einem Analog-Digital-Wandler (V-ADC) der Spannungsmessvorrichtung vorgesehen ist und/oder wobei der zweiten Spannungsmesseinrichtung ein Umschalter (T-MUX) zum wahlweisen Erfassen des Spannungsabfalls (U2) am zweiten Messwiderstandselement (R2) und der am Spannungsabgriffspunkt anliegenden Spannung zugeordnet ist, wobei der Umschalter (T-MUX) insbesondere vor einem Analog-Digital-Wandler (T-ADC) der zweiten Spannungsmesseinrichtung vorgesehen ist.

**15.** Batteriesensor nach einem der Ansprüche 11 bis 12, **dadurch gekennzeichnet, dass** ein Spannungsteiler für die Batteriespannung (Vbat+) vorgesehen ist und der zweiten Spannungsmesseinrichtung ein Umschalter (T-MUX) zum wahlweisen Erfassen des Spannungsabfalls (U2) am zweiten Messwiderstandselement (R2) und der am ersten Batteriesensoranschluss anliegenden Batteriespannung (Vbat+) zugeordnet ist, wobei der Umschalter (T-MUX) insbesondere vor einem Analog-Digital-Wandler (T-ADC) der zweiten Spannungsmesseinrichtung vorgesehen ist.

**Claims**

**1.** Method for operating a battery sensor, comprising at least

- a first battery sensor connection (Vbat+) and a second battery sensor connection (Vbat-),
- a current measurement device for recording a load current (Iload), with a first measuring resistor element (R1) and a second measuring resistor element (R2), wherein the first and the second measuring resistor element (R1, R2) are connected in series between a load current connection and the second battery sensor connection (Vbat-),
- a reference current circuit with at least one reference resistor (Rref, Rref1, Rref2), wherein the reference resistor (Rref, Rref1, Rref2) is in contact with the first battery sensor connection (Vbat+) and a contact point provided between the measuring resistor elements (R1, R2),
wherein the electrical resistance of the first measuring resistor element (R1) is determined by
- switching on a reference current (Iref) and recording the respective resulting voltage drops (U1, U2) across the first and the second measuring resistor element (R1, R2) and the battery voltage (Vbat+),
- determining the reference current (Iref) from the quotient of the battery voltage (Vbat+) and the electrical resistance of the reference resistor (Rref), **characterized by**
- determining the electrical resistance of the first measuring resistor element (R1) from the recorded voltage drops (U1, U2), the reference current (Iref) and at least one correction factor ($\alpha$, $\beta$) that characterizes the relationship between the electrical resistance of the first measuring resistor element (R1) and the electrical resistance of the second measuring resistor element (R2).

**2.** Method according to Claim 1, **characterized in that** the load current (Iload) is determined by

- switching off the reference current (Iref),
- recording at least the voltage drop (U1) across the first measuring resistor element (R1).

**3.** Method according to Claim 2, **characterized in that** a battery state is ascertained by

- recording the battery voltage (Vbat+)

- determining the load current (Iload) from the voltage drop (U1) across the first measuring resistor element (R1), and
- recording a battery parameter using a sensor (Tint, Text), in particular recording a temperature using a temperature sensor.

4.  Method according to one of Claims 1 to 3, **characterized in that** the at least one correction factor ($\alpha$, $\beta$) is determined from the respective voltage drops (U1, U2) and/or the profiles of the voltage drops (U1, U2) of the load current (Iload) across the first and the second measuring resistor element (R1, R2) when the reference current (Iref) is switched off.

5.  Method according to Claim 3, **characterized in that**

    - determining the electrical resistance of the first measuring resistor element (R1),
    - determining the load current (Iload),
    - ascertaining the battery state and/or
    - recording the battery parameter using the sensor (Tint, Text) are repeated alternately, in particular periodically.

6.  Method according to either of Claims 1 and 2, **characterized in that** the reference resistor (Rref) has at least a first reference sub-resistor (Rref 1) and a second reference sub-resistor (Rref 2), and the reference resistance (Rref) is determined by

    - switching the reference current (Iref) into the measuring resistor group consisting of at least the first reference sub-resistor (Rref 1) and the second reference sub-resistor (Rref 2),
    - recording a voltage at a voltage tapping point between the reference sub-resistors (Rref 1, Rref 2),
    - recording the battery voltage (Vbat+),
    - determining the division ratio from the recorded voltage and the recorded battery voltage (Vbat+),
    - determining the electrical resistance of the second reference sub-resistor (Rref 2) from the division ratio and the known electrical resistance of the first reference sub-resistor (Rref 1).

7.  Method according to either of Claims 3 and 5, **characterized in that** the voltage (Vbat+), the voltage drops (U1, U2) and the battery parameter are recorded using three analogue-to-digital converters, wherein a first analogue-to-digital converter (I-ADC) for recording the voltage drop (U1) across the first measuring resistor element (R1), a second analogue-to-digital converter (T-ADC) for selectively recording the voltage drop (U2) across the second measuring resistor element (R2) or the battery parameter of the one sensor (Tint, Text) and a third analogue-to-digital converter (V-ADC) for recording the battery voltage (Vbat+) are provided.

8.  Method according to Claim 7, **characterized in that** a calibration factor of the second or the third analogue-to-digital converter is temporarily determined by applying the same battery voltage (Vbat+), the same voltage drop and/or the same parameter of a sensor to the second and the third analogue-to-digital converter.

9.  Method according to Claim 8, **characterized in that** the battery voltage (Vbat+) is recorded simultaneously using the second analogue-to-digital converter (T-ADC) and the third analogue-to-digital converter (V-ADC).

10. Method according to Claim 8, **characterized in that** a respective voltage present at a voltage tapping point between a first reference sub-resistor (Rref 1) and a second reference sub-resistor (Rref 2) of the reference resistor (Rref) is recorded using the second analogue-to-digital converter (T-ADC) and the third analogue-to-digital converter (V-ADC).

11. Battery sensor for determining a battery state of a battery, in particular a vehicle battery, comprising at least

    - a first battery sensor connection (Vbat+) and a second battery sensor connection (Vbat-),
    - a voltage measurement device for recording the electrical voltage (Vbat+) at the first battery sensor connection,
    - a current measurement device for recording the load current (Iload), with a first measuring resistor element (R1) and a second measuring resistor element (R2), wherein the first and the second measuring resistor element (R1, R2) are connected in series between the load current connection and the second battery sensor connection (Vbat-), and wherein a first and a second voltage measurement apparatus for recording the respective voltage drop (U1, U2) across the first and the second measuring resistor element (R1, R2) are provided,
    - a reference current circuit with at least one reference resistor (Rref, Rref1, Rref2), wherein the reference resistor (Rref, Rref1, Rref2) is in contact with the first battery sensor connection (Vbat+) and a contact point provided between the measuring resistor elements (R1, R2),
**characterized by**
- a controller (μC) for ascertaining the load current (Iload) and the battery state by way of a method according to one of the preceding claims.

12. Battery sensor according to Claim 11, **characterized in that** the voltage measurement device and/or the first and the second voltage measurement apparatuses have an analogue-to-digital converter (V-ADC, T-ADC, I-ADC).

13. Battery sensor according to either of Claims 11 and 12, **characterized in that** at least one sensor (Tint, Text) for recording a battery parameter is provided and **in that** a changeover switch, in particular a multiplexer (T-MUX), for switching between a signal of the second voltage measurement apparatus and a signal of the sensor (Tint, Text) is assigned to the second voltage measurement apparatus, wherein the changeover switch is in particular provided upstream of an analogue-to-digital converter (T-ADC) of the second voltage measurement apparatus.

14. Battery sensor according to either of Claims 11 and 12, **characterized in that** the reference resistor (Rref) has at least two reference sub-resistors (Rref1, Rref2) arranged in series, wherein a voltage tapping point is provided between the reference sub-resistors (Rref1, Rref2), wherein the voltage measurement device is assigned a changeover switch (V-Mux) for selectively recording the battery voltage (Vbat+) or the voltage present at the voltage tapping point, wherein the changeover switch is in particular provided upstream of an analogue-to-digital converter (V-ADC) of the voltage measurement device and/or wherein the second voltage measurement apparatus is assigned a changeover switch (T-MUX) for selectively recording the voltage drop (U2) across the second measuring resistor element (R2) and the voltage present at the voltage tapping point, wherein the changeover switch (T-MUX) is in particular provided upstream of an analogue-to-digital converter (T-ADC) of the second voltage measurement apparatus.

15. Battery sensor according to either of Claims 11 and 12, **characterized in that** a voltage divider for the battery voltage (Vbat+) is provided and the second voltage measurement apparatus is assigned a changeover switch (T-MUX) for selectively recording the voltage drop (U2) across the second measuring resistor element (R2) and the battery voltage (Vbat+) present at the first battery sensor connection, wherein the changeover switch (T-MUX) is in particular provided upstream of an analogue-to-digital converter (T-ADC) of the second voltage measurement apparatus.

**Revendications**

1. Procédé permettant de faire fonctionner un capteur de batterie, comprenant au moins

- une première borne de capteur de batterie (Vbat+) et une deuxième borne de capteur de batterie (Vbat-),
- un dispositif de mesure de courant pour détecter un courant de charge (Iload), comprenant un premier élément de résistance de mesure (R1) et un deuxième élément de résistance de mesure (R2), le premier et le deuxième élément de résistance de mesure (R1, R2) étant connectés en série entre une borne de courant de charge et la deuxième borne de capteur de batterie (Vbat-),
- un circuit de courant de référence comprenant au moins une résistance de référence (Rref, Rref1, Rref2), la résistance de référence (Rref, Rref1, Rref2) étant mise en contact avec la première borne de capteur de batterie (Vbat+) et un point de contact prévu entre les éléments de résistance de mesure (R1, R2),
dans lequel la résistance électrique du premier élément de résistance de mesure (R1) est déterminée par
- la mise en circuit d'un courant de référence (Iref) et la détection des chutes de tension (U1, U2) résultantes respectives par l'intermédiaire du premier et du deuxième élément de résistance de mesure (R1, R2) ainsi que de la tension de batterie (Vbat+),
- la détermination du courant de référence (Iref) à partir du quotient de la tension de batterie (Vbat+) et de la résistance électrique de la résistance de référence (Rref),
**caractérisé par**
- la détermination de la résistance électrique du premier élément de résistance de mesure (R1) à partir des chutes de tension (U1, U2) détectées, du courant de référence (Iref) et d'au moins un facteur de correction (α, β) qui caractérise le rapport entre la résistance électrique du premier élément de résistance de mesure (R1) et la résistance électrique du deuxième élément de résistance de mesure (R2).

2. Procédé selon la revendication 1, **caractérisé en ce que** le courant de charge (Iload) est déterminé par les étapes consistant à

- couper le courant de référence (Iref),
- détecter au moins la chute de tension (U1) par l'intermédiaire du premier élément de résistance de mesure (R1).

3. Procédé selon la revendication 2, **caractérisé en ce qu'**un état de batterie est déterminé par

- la détection de la tension de batterie (Vbat+),
- la détermination du courant de charge (Iload) à partir de la chute de tension (U1) par l'intermédiaire du premier élément de résistance de mesure (R1), et
- la détection d'un paramètre de batterie à l'aide d'un capteur (Tint, Text), en particulier la détection d'une température à l'aide d'un capteur de température.

4. Procédé selon l'une quelconque des revendications 1 à 3, **caractérisé en ce que** ledit au moins un facteur de correction ($\alpha$, $\beta$) est déterminé à partir des chutes de tension (U1, U2) respectives et/ou des tracés des chutes de tension (U1, U2) du courant de charge (Iload) par l'intermédiaire du premier et du deuxième élément de résistance de mesure (R1, R2) lorsque le courant de référence (Iref) est coupé.

5. Procédé selon la revendication 3, **caractérisé en ce que**

- la détermination de la résistance électrique du premier élément de résistance de mesure (R1),
- la détermination du courant de charge (Iload),
- l'établissement de l'état de batterie, et/ou
- la détection du paramètre de batterie par le capteur (Tint, Text) sont répétés en alternance, en particulier périodiquement.

6. Procédé selon l'une quelconque des revendications 1 et 2, **caractérisé en ce que** la résistance de référence (Rref) présente au moins une première résistance partielle de référence (Rref 1) et une deuxième résistance partielle de référence (Rref 2), et la détermination de la résistance de référence (Rref) est effectuée par

- la mise en circuit du courant de référence (Iref) dans le groupe de résistance de mesure à partir au moins de la première résistance partielle de référence (Rref 1) et de la deuxième résistance partielle de référence (Rref 2),
- la détection d'une tension à un point de prélèvement de tension entre les résistances partielles de référence (Rref1, Rref2),
- la détection de la tension de batterie (Vbat+),
- la détermination du rapport de division de la tension détectée et de la tension de batterie (Vbat+) détectée,
- la détermination de la résistance électrique de la deuxième résistance partielle de référence (Rref 2) à partir du rapport de division et de la résistance électrique connue de la première résistance partielle de référence (Rref 1).

7. Procédé selon l'une quelconque des revendications 3 et 5, **caractérisé en ce que** la détection de la tension (Vbat+), des chutes de tension (U1, U2) et la détection du paramètre de batterie sont effectuées à l'aide de trois convertisseurs analogique/numérique, dans lequel un premier convertisseur analogique/numérique (I-ADC) est prévu pour détecter la chute de tension (U1) par l'intermédiaire du premier élément de résistance de mesure (R1), un deuxième convertisseur analogique/numérique (T-ADC) est prévu pour détecter au choix la chute de tension (U2) par l'intermédiaire du deuxième élément de résistance de mesure (R2) ou le paramètre de batterie dudit un capteur (Tint, Text), et un troisième convertisseur analogique/numérique (V-ADC) est prévu pour détecter la tension de batterie (Vbat+).

8. Procédé selon la revendication 7, **caractérisé en ce que** temporairement une détermination du facteur de calibrage du deuxième ou du troisième convertisseur analogique/numérique est effectuée par l'application de la même tension de batterie (Vbat+), de la même chute de tension et/ou du même paramètre d'un capteur au deuxième et au troisième convertisseur analogique/numérique.

9. Procédé selon la revendication 8, **caractérisé en ce que** la tension de batterie (Vbat+) est détectée simultanément par le deuxième convertisseur analogique/numérique (T-ADC) et le troisième convertisseur analogique/numérique (V-ADC).

10. Procédé selon la revendication 8, **caractérisé en ce qu'**une tension appliquée respectivement à un point de prélèvement de tension entre une première résistance partielle de référence (Rref 1) et une deuxième résistance partielle de référence (Rref 2) de la résistance de référence (Rref) est détectée par le deuxième convertisseur analogique/numérique (T-ADC) et le troisième convertisseur analogique/numérique (V-ADC).

11. Capteur de batterie permettant de déterminer un état de batterie d'une batterie, en particulier d'une batterie de véhicule, comprenant au moins

- une première borne de capteur de batterie (Vbat+) et une deuxième borne de capteur de batterie (Vbat-),
- un dispositif de mesure de tension pour détecter la tension électrique (Vbat+) à la première borne de capteur de batterie,
- un dispositif de mesure de courant pour détecter le courant de charge (Iload), comprenant un premier élément de résistance de mesure (R1) et un deuxième élément de résistance de mesure (R2), dans lequel le premier et le deuxième élément de résistance de mesure (R1, R2) sont connectés en série entre la borne de courant de charge et la deuxième borne de capteur de batterie (Vbat-), et dans lequel un premier et un deuxième dispositif de mesure de tension sont prévus pour détecter respectivement la chute de tension (U1, U2) par l'intermédiaire du premier et du deuxième élément de résistance de mesure (R1, R2),
- un circuit de courant de référence comprenant au moins une résistance de référence (Rref, Rref1, Rref2), la résistance de référence (Rref, Rref1, Rref2) étant mise en contact avec la première borne de capteur de batterie (Vbat+) et un point de contact prévu entre les éléments de résistance de mesure (R1, R2), **caractérisé par**
- un dispositif de command ($\mu$C) pour établir le courant de charge (Iload) et l'état de batterie par un procédé selon l'une quelconque des revendications précédentes.

12. Capteur de batterie selon la revendication 11, **caractérisé en ce que** le dispositif de mesure de tension et/ou le premier et le deuxième dispositif de mesure de tension présentent un convertisseur analogique/numérique (V-ADC, T-ADC, I-ADC).

13. Capteur de batterie selon l'une quelconque des revendications 11 et 12, **caractérisé en ce qu'**au moins un capteur (Tint, Text) est prévu pour détecter un paramètre de batterie, et **en ce qu'**un commutateur, en particulier à un multiplexeur (T-MUX), pour commuter entre un signal du deuxième dispositif de mesure de tension et un signal du capteur (Tint, Text) est associé au deuxième dispositif de mesure de tension, dans lequel le commutateur est prévu en particulier avant un convertisseur analogique/numérique (T-ADC) du deuxième dispositif de mesure de tension.

14. Capteur de batterie selon l'une quelconque des revendications 11 à 12, **caractérisé en ce que** la résistance de référence (Rref) présente au moins deux résistances partielles de référence (Rref1, Rref2) disposées en série, dans lequel un point de prélèvement de tension est prévu entre les résistances partielles de référence (Rref1, Rref2), dans lequel un commutateur (V-Mux) pour détecter au choix la tension de batterie (Vbat+) ou la tension appliquée au point de prélèvement de tension est associé au dispositif de mesure de tension, dans lequel le commutateur est prévu en particulier avant un convertisseur analogique/numérique (V-ADC) du dispositif de mesure de tension, et/ou dans lequel un commutateur (T-MUX) pour détecter au choix la chute de tension (U2) et la tension appliquée au deuxième élément de résistance de mesure (R2) et au point de prélèvement de tension est associé au deuxième dispositif de mesure de tension, dans lequel le commutateur (T-MUX) est prévu en particulier avant un convertisseur analogique/numérique (T-ADC) du deuxième dispositif de mesure de tension.

15. Capteur de batterie selon l'une quelconque des revendications 11 à 12, **caractérisé en ce qu'**un diviseur de tension est prévu pour la tension de batterie (Vbat+), et un commutateur (T-MUX) pour détecter au choix la chute de tension (U2) au deuxième élément de résistance de mesure (R2) et la tension de batterie (Vbat+) appliquée à la première borne de capteur de batterie est associé au deuxième dispositif de mesure de tension, dans lequel le commutateur (T-MUX) est prévu en particulier avant un convertisseur analogique/numérique (T-ADC) du deuxième dispositif de mesure de tension.

Fig. 1

Fig. 2

Fig. 3

Fig. 4

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 1378757 A2
- WO 2016041658 A1
- DE 102016202501 A1